(19) Europäisches Patentamt / European Patent Office / Office européen des brevets

(11) EP 4 199 128 A1

(12) **EUROPEAN PATENT APPLICATION**

(43) Date of publication:
**21.06.2023 Bulletin 2023/25**

(21) Application number: **21214775.5**

(22) Date of filing: **15.12.2021**

(51) International Patent Classification (IPC):
***H01L 51/46*** *(2006.01)*

(52) Cooperative Patent Classification (CPC):
**C09B 67/0083; H10K 30/30;** H10K 71/15; H10K 85/657; H10K 85/6576

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Gao, Feng**
  **583 28 Linköping (SE)**
- **Zhang, Rui**
  **583 34 Linköping (SE)**
- **Wan, Li**
  **584 31 Linköping (SE)**

(72) Inventors:
- **Gao, Feng**
  **583 28 Linköping (SE)**
- **Zhang, Rui**
  **583 34 Linköping (SE)**
- **Wan, Li**
  **584 31 Linköping (SE)**

(74) Representative: **AWA Sweden AB**
**P.O. Box 11394**
**404 28 Göteborg (SE)**

# (54) A COMPOSITION FOR DETECTION AND/OR EMISSION OF CIRCULARLY POLARIZED LIGHT IN NEAR-INFRARED REGION AND A DEVICE COMPRISING SUCH A COMPOSITION

(57) The present invention relates to a composition for detection and/or emission of circularly polarized light (CPL) in near infrared (NIR) region. The composition comprises a non-fullerene acceptor (NFA) comprising at least one fused-ring chromophore and a scalemic chiral additive.

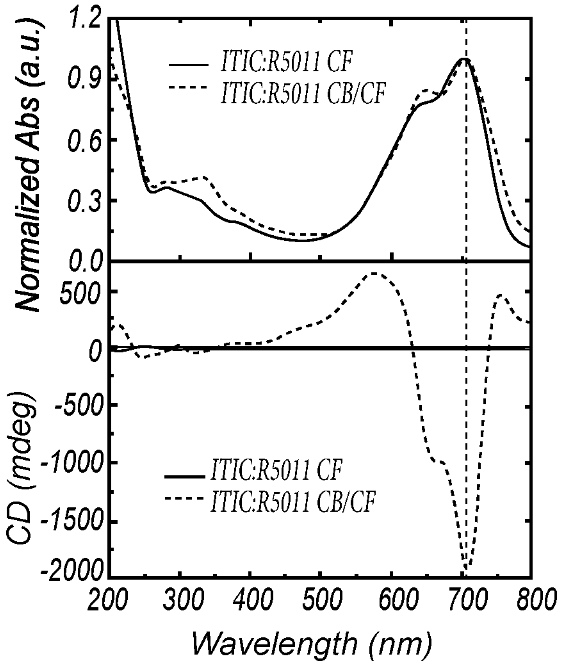


Fig. 1a

EP 4 199 128 A1

**Description**

TECHNICAL FIELD

The present invention relates to a composition for detection and/or emission of circularly polarized light (CPL) in near infrared (NIR) region, to a film comprising such a composition, to an organic electronic device comprising such a composition, and to a method for obtaining a thin film comprising such a composition.

BACKGROUND OF THE INVENTION

Circular polarization of electromagnetic wave has been used in a wide range of applications including satellite communication, bio-imaging, and polarization enhanced sensing technologies. Circularly polarized light (CPL), as a light source, with increased light persistence than non-polarized and linearly polarized light, is more suitable for high-contrast sensing technologies especially in highly scattering environment. Photodetectors matching CPL wavelengths are required to translate the CPL signals to electrical signals. The center of working principles in CPL photodetectors is the ability to discriminate between left- (LH-) and right-handed (RH-) CPL, which can be quantified by dissymmetry factor (g-factor):

$$g = \frac{I_L - I_R}{\frac{1}{2}(I_L + I_R)}$$

where L and R refer to LH-CPL and RH-CPL illumination, respectively. If I is the absorbance, the absorption dissymmetry factor ($g_{abs}$) can be calculated by measuring LH- and RH-CPL absorption spectra using circular dichroism (CD) spectrometer. When building photodetector devices, the photocurrent dissymmetry factor ($g_{ph}$) can be calculated by measuring the photocurrent under LH- and RH-CPL illumination ($j_L$ and $j_R$). When quantifying the emission of CPL, I is replaced by photoluminescence (PL) or electroluminescence intensity (EL) for the calculation of PL and EL dissymmetry factor ($g_{PL}$ and $g_{EL}$).

Besides the desired high $g_{abs}$ or $g_{ph}$, successful employment of CPL photodetector requires a flexible selection of the detection wavelength ($\lambda_{det}$) depending on applications. For long-distance telecommunication technologies, CPL detectors with sensing wavelength over 1000 nm are needed. The absorption of an organic semiconducting material can hardly achieve this range, thus near infrared (particularly, >1000 nm) and mid infrared CPL detection are of great interests for structurally chiral nanostructures based on metamaterial.

The most accessible detection wavelength range of reported CPL detectors is 300 nm - 650 nm. Besides, CD active materials working in this wavelength range includes chiral small molecule dye (ProSQ-C6, $\lambda_{det}$ = 545 nm, Adv. Funct. Mater. 2019, 29, 1900684), chiral fullerenes ($\lambda_{det}$ = 405 nm, Adv. Mater. 2021, 33, 2004115), polymer blends comprising of achiral polymer and chiral additive (F8T2:1-aza[6]helicene, $\lambda_{det}$ = 455 nm, Adv. Opt. Mater. 2021, 2101044), and most recently chiral perovskite ($\lambda_{det}$ = 395nm, 520 nm, and 532 nm, Sci. Adv. 2020, 6, eabd3274). These materials and their detection wavelengths are summarized in Fig. 1. So far, polyfluorene-based blends (CD -14,000 mdeg, Adv. Opt. Mater. 2021, 2101044) and low dimensional perovskites (CD -3,000 mdeg, Sci. Adv. 2020, 6, eabd3274) have demonstrated exceptionally strong chiroptical responses, however, their lowest energy absorption peaks can hardly reach 650 nm and beyond. Reduced band gaps in organics usually rely on planar molecular structures and efficient charge-transport type electronic transitions, which could hardly be observed in chiral molecular systems either with distorted structures and/or reduced conjugation. By embedding perylene diimide (PDI) moieties in helicene structures, the only example of CPL detector for 650 - 1000 nm CPL sensing demonstrates a $g_{abs}$ -0.005 and a $g_{ph}$ -0.01 at $\lambda_{det}$ = 730 nm (Nat. Commun. 2021, 12, 1). However, 730 nm absorption band is not the main absorption band of the material, limiting the photogenerated charge-carriers in OPD devices.

The chiroptical response can be greatly enhanced by both intra and inter-molecular exciton coupling. $\pi$-$\pi$ stacked structures with spatially-close chromophores exhibit strong excited-state energy splitting, which results in intensive couplet CD peaks. Successful demonstration of chiral polyfluorene blends also provides strong evidence that intermolecular solid-state $\pi$ - $\pi$ stacking could further amplify the chiroptical response. However, in terms of the absorption wavelength, the reported systems with $g_{abs}$ > 0.1 are all polyfluorene derivatives, and their peak absorption wavelengths are all below 600 nm.

Organic photodiodes (OPDs), which is a type of photovoltaic and two terminal photodetectors that uses organic electronics, a branch of electronics that deals with (semi)conductive organic polymers or small organic molecules, for light absorption and charge transport to translate optical signal to electric signal by the photovoltaic effect.

Organic photovoltaics are made of electron donor and electron acceptor materials. The materials forming the photoexcited electrons in donor region of photovoltaic cells, where exciton electron-hole pairs are generated, are generally

conjugated polymers possessing delocalized π electrons that result from carbon p orbital hybridization. These π electrons can be excited by light from the molecule's highest occupied molecular orbital (HOMO) to the lowest unoccupied molecular orbital (LUMO). The energy bandgap between these orbitals determines which wavelength(s) of light can be absorbed.

Non-fullerene acceptors (NFAs) with extended planar chromophores and fused-ring structures have been emerging as a hot area in the field of organic photovoltaics since the debut of 3,9-bis(2-methylene-(3-(1,1-dicyanomethylene)-indanone))-5,5,11,11 -tetrakis(4-hexylphenyl)-dithieno[2,3-d:2',3'-d']-s-indaceno[1,2-b:5,6-b']dithiophene (ITIC, Adv. Mater. 2015, 27, 1170) in 2015. Particularly for fused-ring acceptors, altering the core units and end group units could conveniently tune the absorption of the materials from 600 nm to 1000 nm, which sufficiently meets the need to fill the gap of the CPL detection wavelength. These carefully designed electron accepting materials not only accelerate efficiency breakthroughs of OSCs, many of them have also been applied in organic photodiodes (OPDs) with state-of-the-art performance.

Narrow band gap materials (i.e., optical band gap < 2.0 eV; absorption wavelength > 650 nm) require planar molecular chromophore and structures. However, traditional synthetic chiral material design requires disordered, twisted, non-planar structures. It has thus been conceptually contradictory to have both strong circular dichroism (dissymmetry factor > $10^{-2}$ - $10^{-1}$) and dominant absorption band at 650 nm - 1000nm.

In view of the above, there is a need for a composition exhibiting both strong circular dichroism and dominant absorption wavelength at 500 nm - 1000 nm.

SUMMARY OF THE INVENTION

The present invention thus discloses such a composition. The disclosure herein provides an effective approach to directly generate high levels of circularly polarized electroluminescence. It has been determined that blending an achiral non-fullerene acceptor (NFA) comprising at least one fused-ring chromophore with a chiral scalemic small molecule additive will cause the composition to emit and/or absorb right- or left-handed circularly polarized light having a wavelength range from 500 to 1000 nm.

A chromophore is a part of a molecule that may absorb or reflect light of a certain wavelength. Fused-ring systems in which any two adjacent rings have two, and only two, adjacent atoms in common are said to be 'ortho-fused'. Such ring systems have n common sides and 2n common atoms. Fused-ring systems in which a ring contains two, and only two, adjacent atoms in common with each of two or more rings of a contiguous series of ortho-fused rings are said to be 'ortho- and peri-fused'. Such ring systems have n common sides and fewer than 2n common atoms.

Thus, the composition of the present invention for detection and/or emission of circularly polarized light (CPL) in near infrared (NIR) region comprises a non-fullerene acceptor (NFA) comprising at least one fused-ring chromophore and a chiral additive.

In particular, by the term "NIR region" is understood an absorption peak wavelength range from 500 nm to 1000 nm. In particular, the absorption peak wavelength range may be from 650 nm to 1000 nm.

The term "non-fullerene acceptor (NFA) comprising at least one fused-ring chromophore" encompasses a molecule being free from fullerene moieties and being capable of accepting electrons. A fused-ring chromophore comprises a fused-ring structure having at least two rings being fused together. The rings may be aromatic, unsaturated, or saturated. Further, the at least two rings in the fused-ring chromophore may be same or different. One example of NFA of the present invention is fused-ring electron acceptors (FREA) comprising different core units and end group units. The structure of FREA consists of electron withdrawing units in between of an electron donating group, where the electron donating group is a π-bridge of fused aromatic rings. In particular, the number of rings may be up to 15 FREAs are non-chiral molecules with dominant absorption band at 650 nm - 1000nm. Examples of an NFA of the present invention are 3,9-bis(2-methylene-(3-(1,1-dicyanomethylene)-indanone))-5,5,11,11-tetrakis(4-hexylphenyl)-dithieno[2,3-d:2',3'-d']-s-indaceno[1,2-b:5,6-b']dithiophene (ITIC), 5,5'-[(4,9-Dihydro-4,4,9,9-tetraoctyl-s-indaceno[1,2-*b*:5,6-*b'*]dithiophene-2,7-diyl)bis(2,1,3-benzothiadiazole-7,4-diylmethylidyne)]bis[3-ethyl-2-thioxo-4-thiazolidinone] (o-IDTBR) and 2,2'-[[12,13-Bis(2-ethylhexyl)-12,13-dihydro-3,9-diundecylbisthieno[2″,3″:4',5']thieno[2',3':4,5]pyrrolo[3,2-*e*:2',3'-*g*][2,1,3]benzothiadiazole-2,10-diyl]bis[methylidyne(5,6-difluoro-3-oxo-1*H*-indene-2,1(3*H*)-diylidene)]]bis[propanedinitrile] (Y6), a.k.a. BTP-4F, and analogues thereof.

An achiral NFA in isolation, i.e. in the absence of a chiral additive, will not generate or absorb circularly polarized light.

Particular non-limiting examples of NFAs according to the present invention are shown below. General Structure of FREAs:

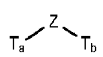

Z =

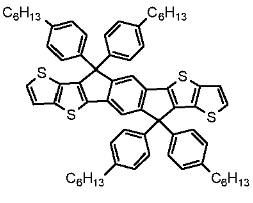

Z1

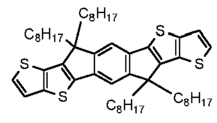

Z2

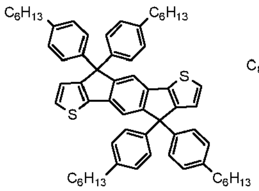

Z3

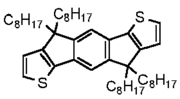

Z4

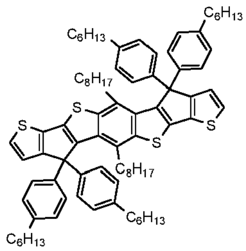

Z5

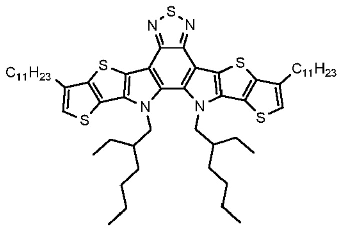

Z6

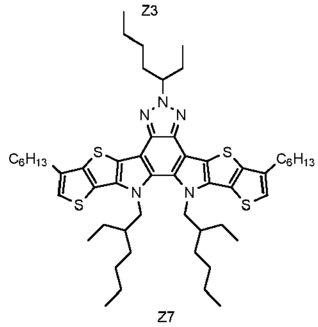

Z7

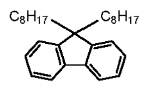

Z8

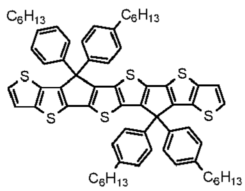

Z9

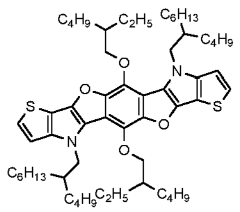

Z10

$T_a$, $T_b$ =

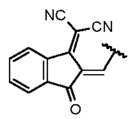

T1

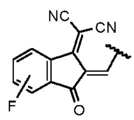

T2

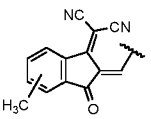

T3

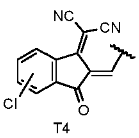

T4

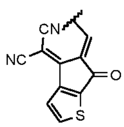

T5

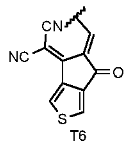

T6

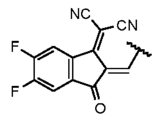

T7

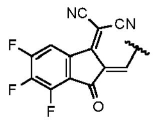

T8

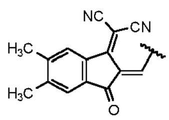

T9

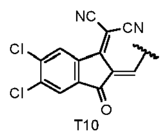

T10

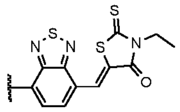

T11

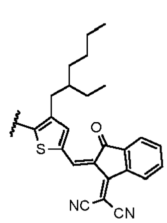

T12

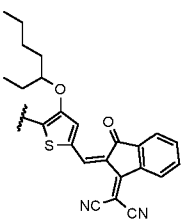

T13

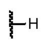

T14

In particular, NFAs may be o-IDTBR (T11-Z8-T11), IEICO (T13-Z3-T13), Y18 (2,2'-((2Z,2'Z)-((12,13-bis(2-ethylhexyl)-6-(heptan-3-yl)-3,9-dihexyl-12,13-dihydro-6H-thieno[2",3":4',5']thieno[2',3':4,5]pyrrolo[3,2-g]thieno[2',3':4,5]thieno[3,2-b][1,2,3]triazolo[4,5-e]indole-2,10-diyl)bis(methaneylylidene))bis(5,6-difluoro-3-oxo-2,3-dihydro-1H-indene-2,1-diylidene))dimalononitrile, T7-Z7-T7) as shown in Fig. 2 and will be described in greater detail below. Each instance of an aromatic, heteroaromatic, carbocyclic or heterocyclic group may, independently, optionally be substituted by one or more substituents selected from the group comprising, but not limited to halo, nitro, cyano, -R*, haloaliphatic, aryl(aliphatic), aryl(heteroaliphatic), heteroaryl(aliphatic), heteroaryl(heteroaliphatic), -OR*, -C(O)R*, -OC(O)R*, -OC(O)OR*, -C(O)OR*, $-NR^*_2$ , $-C(O)NR^*_2$ , - NR*C(O)R*, - $NR^*C(O)N(R^*)_2$, - $NR^*CO_2R^*$, $-OC(O)N(R^*)_2$,

-SR*, -S(O)R*, -S(O)$_2$R*, -S(O)$_2$NR*, -C(= NR*)-N(R*)$_2$, C(= NR*)-OR*, -N(R*)-N(R*)$_2$, -OS(O)$_2$R*, -N(R*)C(=NR*)-N(R*)$_2$, -NR*SO$_2$R*, -NR*SO$_2$N(R*)$_2$, -P(R*)$_2$, -P(O)(R*)$_2$, -P(O)(OR*)$_2$, -O-P(O)-OR*, and -P(O)(NR*)-N(R*)$_2$. In some embodiments, two adjacent substituents, taken together with intervening ring atoms, form an optionally substituted 6- membered fused aromatic ring, 5- or 6- membered fused heteroaromatic ring, or 4- to 8-membered fused carbocyclic or heterocyclic ring. Each instance of R* is, independently, hydrogen, or optionally substituted aliphatic, heteroaliphatic, aryl or heteroaryl, or wherein two R* moieties attached to the same nitrogen atom may optionally join to form a ring including the nitrogen atom. It will be understood that the substituent moieties listed above may themselves be optionally substituted, with one or more or the substituents listed above. Optional substituents on a repeating unit of a Ta and/or a Tb and/or a Z structure, for example, be selected from the substituents listed above.

The term "scalemic chiral additive" in the context of the present invention means a chiral molecule in a non-racemic form, i.e. non-racemic mixture of enantiomers or an enantiopure form. Enantiopurity may be measured, for example, by chiral HPLC or by NMR with chiral shift reagents.

An "additive" as referred to herein is present blended together with an NFA in a mixture to form a composition of the invention. In other words, the additive is not covalently bonded to the NFA.

The chiral additive of the present invention may be an axially chiral molecule, a helical molecule, a chiral liquid crystal molecules or combination thereof.

The chiral additive may be a helical compound, for example selected from the group consisting of, but not limited to, a helicene, a helicenoidal compound, a helical peptide, and a DNA molecule. In particular, the chiral additive may be 6-helicene. Further, the chiral additive may be an axially chiral biaryl compound.

A 'helicene' as referred to herein is a helical polycyclic aromatic or heteroaromatic compound. Helicenes are helically shaped (and therefore chiral) conjugated molecules comprising a spiral of four or more ortho-fused aromatic or heteroaromatic rings. Helicenes can be separated into their right-handed and left-handed enantiomeric forms, for example by chiral HPLC. A helicene optionally comprises a mixture of aromatic and heteroaromatic rings. The aromatic or heteroaromatic rings of a helicene are optionally substituted.

A 'helicenoidal compound' as referred to herein is a non-fully conjugated helical polycyclic compound. A helicenoidal compound comprises fused, optionally substituted cyclic (aromatic, heteroaromatic, carbocyclic, heterocarbocyclic, or a mixture thereof) groups, but is not fully conjugated. Preferably, a helicenoidal compound comprises a spiral of 4 or more ortho-fused cyclic groups.

A 'helicene' or 'helicenoidal compound' comprises four or more optionally substituted ortho-fused cyclic groups forming a spiral configuration. Whilst there is no upper limit to the number of ortho-fused cyclic groups in a 'helicene' or 'helicenoidal compound', compounds with up to 15 fused rings are preferred. Thus, a 'helicene' or 'helicenoidal compound' is preferably a compound comprising 4 to 15 (for example 4 to 10) optionally substituted ortho-fused cyclic groups.

A 'biaryl compound' is a compound comprising two bonded aromatic or heteroaromatic groups, each of which is, independently, optionally substituted and/or fused to one or more carbocyclic or heterocyclic rings.

An 'aromatic group", also referred to as an "aryl group" may be a mono-, bi- or tricyclic aromatic ring system, preferably a 6-14 membered ring system. A 'heteroaromatic group', also referred to as a "heteroaryl group" may be a mono-, bi- or tri- cyclic heteroaromatic ring system, in which one or more ring atoms is a heteroatom selected from O, N or S, preferably a 5-14 membered ring system.

Exemplary axially chiral biaryl compounds include BINAP (2,2'-bis(diphenylphosphino)-1, 1'- binaphthyl), H8-BINAP, and BINOL (1,1'-Bi-2-naphthol).

Each instance of an aromatic, heteroaromatic, carbocyclic or heterocyclic group may, independently, optionally be substituted by one or more substituents selected from the group comprising, but not limited to halo, nitro, cyano, -R*, haloaliphatic, aryl(aliphatic), aryl(heteroaliphatic), heteroaryl(aliphatic), heteroaryl(heteroaliphatic), -OR*, -C(O)R*, -OC(O)R*, -OC(O)OR*, -C(O)OR*, -NR*$_2$, -C(O)NR*$_2$, - NR*C(O)R*, - NR*C(O)N(R*)$_2$, - NR*CO$_2$R*, -OC(O)N(R*)$_2$, -SR*, -S(O)R*, -S(O)$_2$R*, -S(O)$_2$NR*, -C(= NR*)-N(R*)$_2$, C(= NR*)-OR*, -N(R*)-N(R*)$_2$, -OS(O)$_2$R*, -N(R*)C(=NR*)-N(R*)$_2$, -NR*SO$_2$R*, -NR*SO$_2$N(R*)$_2$, -P(R*)$_2$, -P(O)(R*)$_2$, -P(O)(OR*)$_2$, -O-P(O)-OR*, and -P(O)(NR*)-N(R*)$_2$. In some embodiments, two adjacent substituents, taken together with intervening ring atoms, form an optionally substituted 6- membered fused aromatic ring, 5- or 6- membered fused heteroaromatic ring, or 4- to 8-membered fused carbocyclic or heterocyclic ring. Each instance of R* is, independently, hydrogen, or optionally substituted aliphatic, heteroaliphatic, aryl or heteroaryl, or wherein two R* moieties attached to the same nitrogen atom may optionally join to form a ring including the nitrogen atom. The aliphatic chains (e.g. $C_8H_{17}$ or hexyl chains) can be modified to comprise more carbon atoms. Also, the hydrogens on the aromatic rings may be substituted with other aliphatic and aromatic chains. It will be understood that the substituent moieties listed above may themselves be optionally substituted, with one or more or the substituents listed above. Optional substituents on a repeating unit of a Ta and/or a Tb and/or a Z structure or a monomeric unit of NFA, for example, be selected from the substituents listed above.

An 'aliphatic' group is an alkyl, alkenyl or alkynyl group. The term "alkyl" includes straight- chain, branched and cyclic alkyl groups, for example having 1-20, 1-10 or 1-6 carbon atoms. The term "alkenyl" includes straight-chain, branched and cyclic alkenyl groups, for example having 2-20, 2-10 or 2-6 carbon atoms. The term "alkynyl" includes

straight-chain and branched alkynyl groups, for example having 2-20, 2-10 or 2-6 carbon atoms. A "heteroaliphatic" group is an aliphatic group as defined above in which one or more carbon has been replaced with a heteroatom selected from O, S, N or P. A "carbocyclic group" is a cyclic aliphatic group, preferably 4- to 14- membered and a "heterocarbocyclic group" is a cyclic heteroaliphatic group, preferably 4- to 14- membered.

In particular, the chiral additive may be selected from a group consisting of:

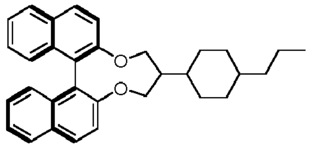

A1

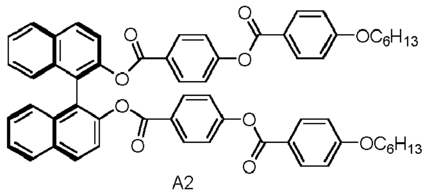

A2

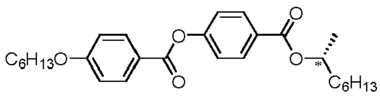

A3

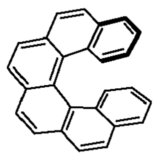

A4

A1: (13b*R*)-5,6-Dihydro-5-(*trans*-4-propylcyclohexyl)-4*H*-dinaphtho[2,1-*f*:1',2'-*h*][1,5]dioxonin; A2: (S)-[1,1'-binaphthalene]-2,2'-diyl bis(4-((4-(hexyloxy)benzoyl)oxy)benzoate); A3: 4-[[[(1*R*)-1-Methylheptyl]oxy]carbonyl]phenyl 4-(hexyloxy)benzoate; A4: [*M*]-6-helicene

In particular, R5011 (additive A1) offer the advantage of being economically beneficial. Alternatively, or additionally, (13b*S*)-5,6-Dihydro-5-(*trans*-4-propylcyclohexyl)-4*H*-dinaphtho[2,1-*f*:1',2'-*h*][1,5]dioxonin (S5011) may be used as a scalemic chiral additive. When a mixture of R5011 and S5011 is used, it is importance that the mixture is non-racemic (scalemic).

The chiral additive may preferably have weight average molecular weight Mw of up to 4000.

In some embodiments, the chiral additive is provided at an enantiopurity of at least 30% ee, at least 40%, at least 50%, at least 60%, at least 70% ee, at least 80% ee, at least 90% ee, at least 95% ee or at least 99% ee.

The chiral additive could induce a helical molecular packing structure which enables strong intermolecular electronic circular dichroism in FREA materials. The blend film can then be used for circularly polarized sensing and emission at >650 nm.

The ratio between the chiral additive and the NFA may be in the range from 0.1:99.9 to 90:10 wt%. In particular, the ratio between the chiral additive and the NFA may be 10:90 wt%.

The composition of the present invention may further comprise at least one main solvent. In particular, the main solvent may be chloroform. The composition may comprise at least two main solvents.

The composition according to the present invention may further comprise at least one auxiliary solvent having a boiling point of at least 80°C. In particular, the auxiliary solvent may be chlorobenzene. The composition may comprise a plurality of auxiliary solvents, each having a boiling point of at least 80°C. By the term "plurality" is understood as two or more.

The ratio between the main and the auxiliary solvent may in the range from 99.99:0.01 to 0:100 vol%. Depending on the NFA and the chiral additive, the ratio of the main and the auxiliary solvent should be selected such that the CD signal is maximized without compromising solubility of the NFA and/or the chiral additive. In particular, the ratio between the main and the auxiliary solvent is 90:10 vol%.

The present invention further relates to a film comprising a composition described above, wherein the film exhibits circular dichroism (CD) at 500 - 1000 nm. The film may be useful for CPL detection from 500 - 1000 nm. In some embodiments, the film may be useful as a photoluminescent film or coating, which can be made to emit CP light by excitation at 500 nm - 1000 nm from a light source (a light emitting diode or a laser diode).

The film according to the present invention may have a thickness in the range from 50 to 500 nm, preferably from 100 to 300 nm, more preferably from 150 to 250 nm.

The present invention further relates to an organic electronic device for detection and/or emission of CPL in NIR region, wherein the device comprises an active layer comprising an optional electron donor material and a composition as described above.

The electron donor material may be a polymer, such as poly[[4,8-bis[5-(2-ethylhexyl)-2-thienyl]benzo[1,2-b:4,5-b']dithiophene-2,6-diyl]-2,5-thiophenediyl[5,7-bis(2-ethylhexyl)-4,8-dioxo-4H,8H-benzo[1,2-c:4,5-c']dithiophene-1,3-diyl]] polymer (PBDB-T).

The organic electronic device may be a circularly polarized organic photodiode (CP-OPD), a photoconductor or a phototransistor. In some embodiments, the diode or the transistor may be emissive (at a higher voltage or at reverse bias to OPD operating voltage) and be operated as a light-emitting diode or light-emitting transistor to emit CPL.

As mentioned above, the organic electronic device has the ability to detect circularly polarized light signals in the range from 500 nm to 1000 nm, in particular from 600 nm to 850 nm.

The organic electronic device of the present invention may have different photocurrent when exposed to left- and right-handed CPL from 500 nm to 1000 nm.

The present invention relates to a method for obtaining a thin film comprising a composition for detection and/or emission of circularly polarized light (CPL) in near infrared (NIR) region, the method comprising the steps of:

a) providing an ink comprising a non-fullerene acceptor (NFA) comprising at least one fused-ring chromophore, a chiral additive and at least one auxiliary solvent having a boiling point of at least 80°C;
b) applying said ink to a substrate thus providing a thin film thereon.

The ink may be applied to the substarte by any method known in the art, such as spin coating, blade coating, drop-casting, and printing.

The thin film may be obtained by co-evaporation of the composition described above on a substrate. The co-evaporation may be a thermal evaporation.

By tuning the contents and nature of the main and the auxiliary solvent of ink, the invention demonstrates a possibility to induce strong CD in NFA thin film. Owing to the embedded asymmetric $\pi$ - $\pi$ stack, ITIC demonstrates great sensitivity to 700 nm CPL in both thin films and devices, as an example of many developed NFAs for photovotaics. The chiroptical activities in chiral ITIC blends is strongly associated with the exciton coupling of adjacent ITIC molecules and could be further amplified by in-plane rotation of ITIC chains and out-of-plane $\pi$ - $\pi$ stack. The compositions comprising other NFAs, such as o-IDTBR (Nat. Commun. 2016, 7, 11585), IEICO Adv. Mater. 2016, 28, 8283) and Y18 (J. Mater. Chem. A 2020, 8, 8566.) exhibited CD bands that can be flexibly tuned from 600 nm to 1000 nm by their molecular structures, which can effectively fill the gap of the detection wavelength of existing chiral systems. Compared to fullerene systems, NFAs designed for OSCs exhibit strong absorption coefficient, enhancing the photogeneration of charge-carriers, which are also prerequisite for efficient photodetectors.

## BRIEF DESCRIPTION OF THE DRAWINGS

Embodiments of the invention will now be described by way of example with reference to the accompanying drawings, of which:

Fig. 1 depicts thin-film (a) absorption and CD spectra of ITIC:R5011 (10:90 wt%) blends deposited from neat CF and CF/CB = 9:1 mixed solvent; (b) molecular structure of ITIC, R5011, S5011; and (c) rescaled CD spectra of neat ITIC thin films deposited from neat CF;

Fig. 2 illustrates absorption (a) and CD (b) spectra of neat ITIC thin films deposited from neat CF and mixed CF/CB solvent;

Fig. 3 shows absorption (a) and CD (b) spectra of neat R5011 thin films deposited from neat CF and mixed CF/CB solvent;

Fig. 4 depicts CD spectra (a) and extracted $g_{abs}$ (b) of R5011:ITIC = 1:9 thin films deposited from solvents with increasing CB contents;

Fig. 5 illustrates CD spectra of R5011:ITIC = 1:9 thin films deposited from CF/CB=1:9 mixed solvent while rotating and flipping the sample;

Fig. 6 shows (a) Absorption and (b) CD spectra of R5011:ITIC = 1:9 thin films deposited from neat CF solvent and mixed solvent with 10 vol% of THF (tetrahydrofuran), 2-butanol, toluene, CB(chlorobenzene), m-xylene, o-xylene, and anisole; (c) Extracted $g_{abs}$ from (b); (d) peak $g_{abs}$ plotted as a function of boiling point of the auxiliary solvent;

Fig. 7 depicts peak CD values as a function of the amount of the chiral additive;

Fig. 8 illustrates (a) CD spectra of binary and ternary R/S5011 blended thin films (R/S5011:ITIC:PBDB-T = 50:90:90

wt%) deposited from CF/CB = 9:1 mixed solvent; (b) Extracted $g_{abs}$ of binary and ternary R5011 blended films from (a); (c) J-V characteristics of R5011 blend OPD recorded in dark and upon unpolarized illumination with increasing light intensity; (d) Linear fit of photocurrent as a function of light intensity extracted from (c) at -2.0 V; (e) J-V characteristics of R5011 blend OPD recorded under illumination of LH and RH-CPL (700 nm, 10 mW/$cm^2$), Inset is zoomed-in curve plotted in linear scale; (f) $g_{ph}$ of R/S5011 blend CP-OPD as a function of voltage;

Fig. 9 shows CD spectra collected from R5011 blend thin films deposited from mixed solvent of other generation of NFA developed for highly efficient organic solar cells. IDTBR derivative: (a) o-IDTBR. ITIC analogues: (b) ITIC-4Cl (Adv. Mater., 2018, 30, 1800613), (c) IEICO, (d) IT-M (Adv. Mater. 2016, 28, 9423.), and (e) ITTC (Sol. RRL 2017, 1, 1700044). Y6 analogue: (f) Y18;

Fig. 10 shows circularly polarized photoluminescence of R5011:ITIC blends. $g_{PL}$ is calculated following $g_{PL} = 2*(I_L-I_R)/(I_L+I_R)$.

DETAILED DESCRIPTION OF THE INVENTION

Chiral additives R/S5011 were purchased from Nanjing Sanjiang Advanced Materials R&D Co., Ltd. All NFAs and PBDB-T were purchased from Solarmer Materials Inc. All materials were used without further purification.

Solution Preparation and Thin Film Deposition

ITIC and R5011 were dissolved in neat CF and CF/CB mixed solvent to a concentration of 20 mg/mL and blended to form a 10 wt% R5011 solution. Thin films were dynamically spin-coated with a speed of 2000 rpms to give a -120 nm film and deposited on clean fused silica substrates. The cleaning process for all substrates involved rinsing in an ultrasonic bath with acetone, isopropyl alcohol (IPA), Hellmanex III (Sigma-Aldrich), and deionized water for 15 min. These were followed by a UV-ozone treatment for 15 min before spin-coating. All samples are measured without annealing and other post-deposition treatments. Thickness of the thin films was controlled by spin speed and monitored using a Dektak XT surface profiler.

Photophysical and Morphological Characterization

CD spectra and absorption spectra were collected simultaneously using a Chirascan (Applied Photophysics) spectrophotometer. The dissymmetry factor $g_{abs}$ was calculated following the equation

$$g = \frac{A_L - A_R}{A}$$

$|g| \leq 2$. The two-dimensional Grazing incidence X-ray diffraction (2D GIWAXS) measurement was carried out at the 14BL beamline of Shanghai Synchrotron Radiation Facility (SSRF) ($\lambda$ = 1.24 Å) in Shanghai, China. The sample stage was equipped with a 7-axis motorized stage for the fine alignment of the sample, and the incidence angles of the X-ray beam were set to be 0.2 for the neat and blend films. The GIWAXS patterns were recorded with a 2D CCD detector and an X-ray irradiation time within 100 s, dependent on the saturation level of the detector.

OPD Fabrication and Characterization

Prepatterned indium tin oxide (ITO) glass substrates were sequentially cleaned in an ultrasonic bath with water solution of surfactant, acetone, and isopropanol (15 min each) and dried under $N_2$ flow before UV Ozone treatment. The PEIE solution (80% ethoxylated; 37 wt% in H2O, Sigma-Aldrich) was further diluted to 0.45 wt% in deionized water, and spin-coated to ITO substrates at 5000 rpm for 60 s on a spin coater. Then they were transferred to a $N_2$ glovebox immediately. The R5011, ITIC, PBDB-T were blended in a weight ratio of 5:9:9 in CB/CF mixed solvent (CB/CF = 10:90 vol%) with total concentration of 27 mg/mL and deposited to the PEIE layer to form a 200 $\pm$ 10 nm film. Afterward, Au was thermally evaporated onto the organic layer under high vacuum ($\approx 1\times$ 10-6 mbar). J-V (device pixel area = 0.047 $cm^2$) was performed using a Keithley 2400. For illuminated measurements, mounted LED (Thorlabs, 700 nm, M700L4) was used, which was collimated with an adaptor lens (Thorlabs, SM2F32-A). For measurements of $g_{ph}$ under reverse bias, the collimated LED was circularly polarized using an ultra-broadband wire grid polarizers (Thorlabs, WP25M-UB with an extinction ratio of > 1000:1 at 700 nm) and a mounted quarter-wave fresnel rhomb retarder (FR600QM, retardance variation < 2% for 600-1550 nm). The collimated beam size of the polarized LED is 9 $mm^2$, fully covering the device

active area. The light intensity was monitored using a UV enhanced Si photodetector (Newport, 200 - 1100 nm).

To demonstrate the versatility of the composition of the present invention, a low-cost axially chiral additive R/S5011 (chiral additive A1 above) was chosen to blend with NFAs. ITIC (T1-Z1-T1 above) is a well-studied FREA, featuring a symmetric indacenodithieno[3,2-b]-thiophene (IDTT) core and two 1,1-dicyanomethylene-3-indanone (IC) end group units. The photophysical properties of neat ITIC and ITIC:R/S5011 (Fig. 1a) binary blends deposited from different solvents were investigated. When deposited from neat solvent chloroform (CF), neat ITIC films exhibit clear vibronic absorption peaking at $\lambda$ -700 nm, owing to a higher energy $\pi$ - $\pi^*$ transition and an IDTT to IC charge-transfer type transition. Without stereogenic centers, as expected, ITIC thin films exhibit virtually silent CD signals, independent of the spin-coating solvent (Fig. 2). By blending 10 wt% R5011, the CD spectra of the blend film only shows a weak CD signal (~ 40 mdeg, Fig. 1c) corresponding to R5011 absorption at $\lambda$ = 240 nm (Fig. 3), and no chiroptical activity was observed in ITIC electronic transitions. By adding 10 vol% auxiliary solvent chlorobenzene (CB) to the spin-coating solution (i.e., CF/CB = 9:1), the main absorption band of ITIC thin film becomes broader and slightly red-shifted, indicating a larger distribution of electronic states. This is accompanied by a strong negative CD signal of ~-2000 mdeg ($g_{abs}$ ~-0.06) at $\lambda$ = 706 nm (Fig. 1a).

Further increasing CB contents in the mixed solvent will result in poorer solubility of ITIC, causing a $g_{abs}$ decrease (Fig. 4). The CD spectra show no change after rotation or flipping the sample (Fig. 5), suggesting negligible linear dichroism - linear birefringence (LD-LB) effect in the measured CD signals.

To investigate the role of the auxiliary solvent, the CD spectra change of the blend films (R5011:ITIC = 10:90 wt%) deposited from mixed solvents consisting of CF and 10 vol% auxiliary solvents with varying boiling point ($T_b$) were studied. When low $T_b$ auxiliary solvent, such as tetrahydrofuran (THF) and 2-butanol were chosen, negligible CD response can be observed (Fig. 6b). However, when the $T_b$ of the auxiliary solvent is above 80 °C, strong CD peaks at -700 nm can be observed. Remarkably, $|g_{abs}|$ increases with the increasing $T_b$ of the auxiliary solvent (Fig. 6c).

Fig. 7 illustrates the effect of the amount of the chiral additive in the composition on the peak CD. Thus, thin films were deposited from a 20 mg/mL solution on CB/CF mixed solvent (CB/CF = 1:9 vol%). The film thickness was ~ 120 nm. As may be seen in Fig. 7, the optimal peak CD is obtained at the loading of the chiral additive being between 30 and 40%.

To build an active layer for CP-OPDs, donor polymers, such as PBDB-T may be added in the ITIC:R5011 to form a bulk heterojunction blend. The ternary blends exhibit slightly reduced CD -3000 mdeg and $|g_{abs}|$ of ~0.09, compared to its binary counterparts (CD -4000 mdeg, $|g_{abs}|$ -0.15 at $\lambda$ = 700 nm, Fig. 8a and 8b), indicating PBDB-T only slightly interrupts the interaction between ITIC and R5011. Proof-of-concept single-layer CP-OPDs were fabricated using a device structure of ITO/PEIE/R5011:ITIC:PBDB-T/Au according to the procedure above. The dark current density of the optimized CP-OPD was 2.86 $\times$ $10^{-8}$ A/cm$^2$ (at -2V, Fig. 8c), which is comparable to the lowest value reported for CP-OPDs so far. Upon illumination at $\lambda$ = 700 nm with increased light power density (P) from 0.0018 mW/cm$^2$ to 10.34 mW/cm$^2$, the current density gradually increased from 9.57 $\times$ $10^{-8}$ to 1.78 $\times$ $10^{-4}$ A/cm$^2$ (at -2.0 V). The calculated responsivity was 17.1 mA/W following the equation of R= J/P (Fig. 8d). In terms of CPL sensitivity, the R5011 blend device exhibit photocurrent jL and jR of 7.54 $\times$ $10^{-2}$ and 8.24 $\times$ $10^{-2}$ mA/cm$^2$ (at -1.0 V, Fig. 8e) under the illumination of LH- and RH-CPL. The extracted $g_{ph}$ was -0.089 (at -1.0 V) for R5011 blend device, and S5011 blend device exhibits a mirror-image gph (Fig. 8f). These results indicate that the chiral additives can effectively functionalize the OPDs with great sensitivity towards CPL signals without having a detrimental effect of the device performance when it was operated as an unpolarized OPD.

Considering the above, it has been demonstrated that NFAs is directly induced with chiroptical activity in NFA systems by blending chiral additives. The annealing-free ITIC blends exhibit exceptionally strong CD response (>4000 mdeg, $g_{abs}$ -0.15) and the proof-of-concept CP-OPDs demonstrate a $|g_{ph}|$ of 0.089 with a low dark current of 2.86 $\times$ $10^{-8}$ A/cm$^2$ (at -2V). The composition of the present invention could promote the application of CPL sensing with extended detection wavelength.

The strategy of the present invention is generally applicable to other types of state-of-the-art NFAs, examples of CD spectra of blend films based on o-IDTBR, IEICO, Y18 and many more analogues and derivatives (Fig. 9). The CD bands of these systems can be flexibly tuned from 500 nm to 1000 nm *via* modification of chemical structures.

Finally, Fig. 10 depicts circularly polarized photoluminescence of R5011:ITIC (10:90 wt%) blend film deposited from a CF/CB (10:90 vol%) mixed solvent wherein $g_{PL}$ is calculated according to the following formula:

$$g_{PL} = 2*(I_L-I_R)/(I_L+I_R).$$

Although the present invention has been described with reference to various embodiments, those skilled in the art will recognize that changes may be made without departing from the scope of the invention. It is intended that the detailed description be regarded as illustrative and that the appended claims including all the equivalents are intended to define the scope of the invention.

**Claims**

1. A composition for detection and/or emission of circularly polarized light (CPL) in near infrared (NIR) region, said composition comprising:

   a non-fullerene acceptor (NFA) comprising at least one fused-ring chromophore;
   a scalemic chiral additive.

2. The composition according to claim 1, wherein the chiral additive is a helical compound.

3. The composition according to any one of the preceding claims, wherein the non-fullerene acceptor (NFA) is a fused-ring small molecule compound having an absorption band in the range from 500 nm to 1000 nm.

4. The composition according to any one of the preceding claims, wherein said CPL has the wavelength in the region from 500 nm to 1000 nm.

5. The composition according to any one of the preceding claims, wherein said composition further comprises at least one main solvent.

6. The composition according to any one of the preceding claims, wherein said composition further comprises at least one auxiliary solvent having a boiling point of at least 80°C.

7. The composition according to claim 6, wherein said auxiliary solvent is toluene, CB(chlorobenzene), m-xylene, o-xylene, anisole, and derivatives and mixtures thereof.

8. The composition according to any one of claims 6 or 7, wherein the ratio between said main and said auxiliary solvent is in the range from 99.99:0.01 to 0:100 vol%.

9. The composition according to any one of claims 6-8, wherein said composition comprises a plurality of auxiliary solvents, wherein each auxiliary solvent of said plurality of auxiliary solvents has a boiling point of at least 80°C.

10. The composition according to any one of the preceding claims, wherein the ratio between said scalemic chiral additive and said NFA is in the range from 0.1:99.9 to 90:10 wt%.

11. A film comprising a composition according to any one of claims 1-10, wherein said film exhibits circular dichroism (CD) at NFA absorption wavelength.

12. The film according to claim 11, wherein said film has a thickness in the range from 50 to 500 nm.

13. An organic electronic device for detection and/or emission of CPL in NIR region, wherein said device comprises an active layer comprising a composition according to any one of claims 1-10.

14. The organic electronic device according to claim 13, wherein said device is a circularly polarized organic photodiode (CP-OPD), a photoconductor or a phototransistor, an emitting diode, or an emitting transistor.

15. A method for obtaining a thin film comprising a composition for detection and/or emission of circularly polarized light (CPL) in near infrared (NIR) region, said method comprising the steps of:

   a) providing an ink comprising a non-fullerene acceptor (NFA) comprising at least one fused-ring chromophore, a chiral additive and at least one auxiliary solvent having a boiling point of at least 80°C;
   b) applying said ink to a substrate thus providing a thin film thereon.

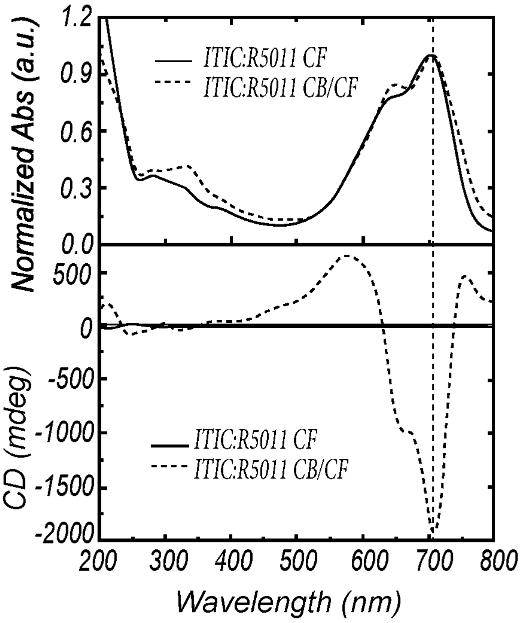


Fig. 1a

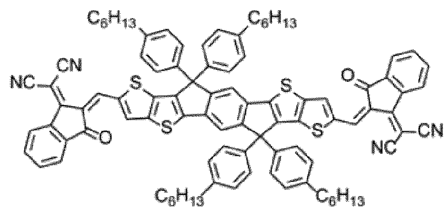

ITIC

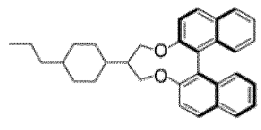

S5011

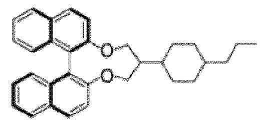

R5011

Fig. 1b

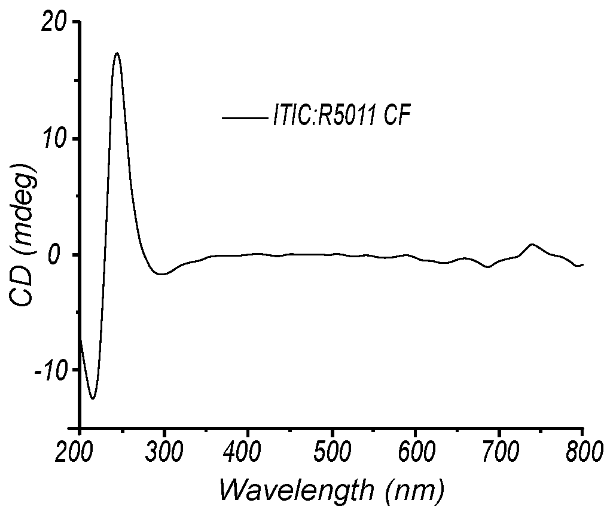


Fig. 1c

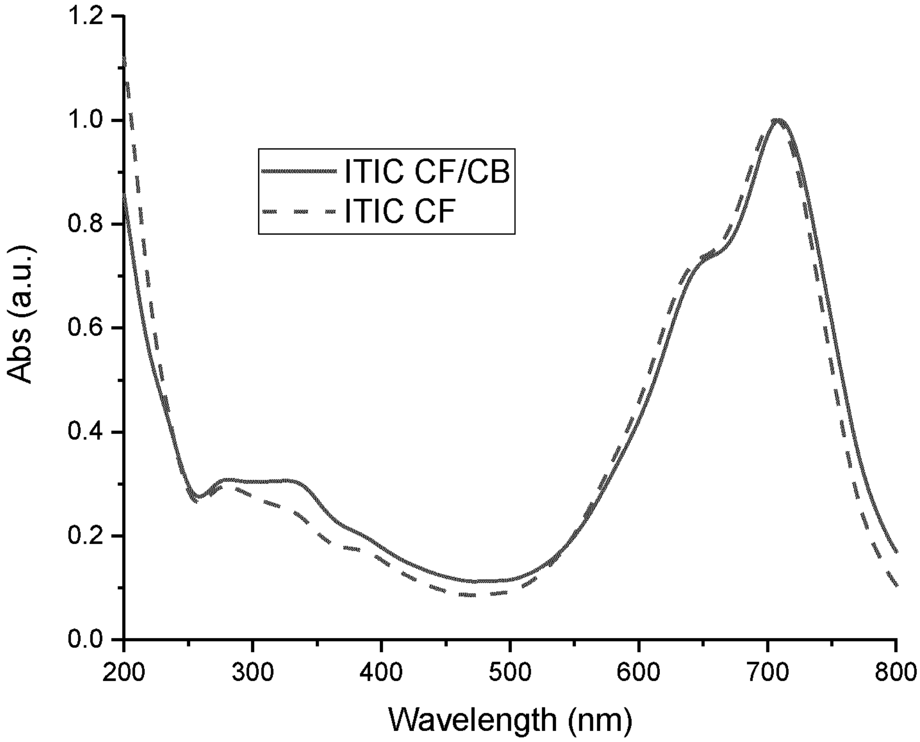
1.2
1.0
0.8
0.6
0.4
0.2
0.0
Abs (a.u.)
ITIC CF/CB
ITIC CF
200
300
400
500
600
700
800
Wavelength (nm)

Fig. 2a

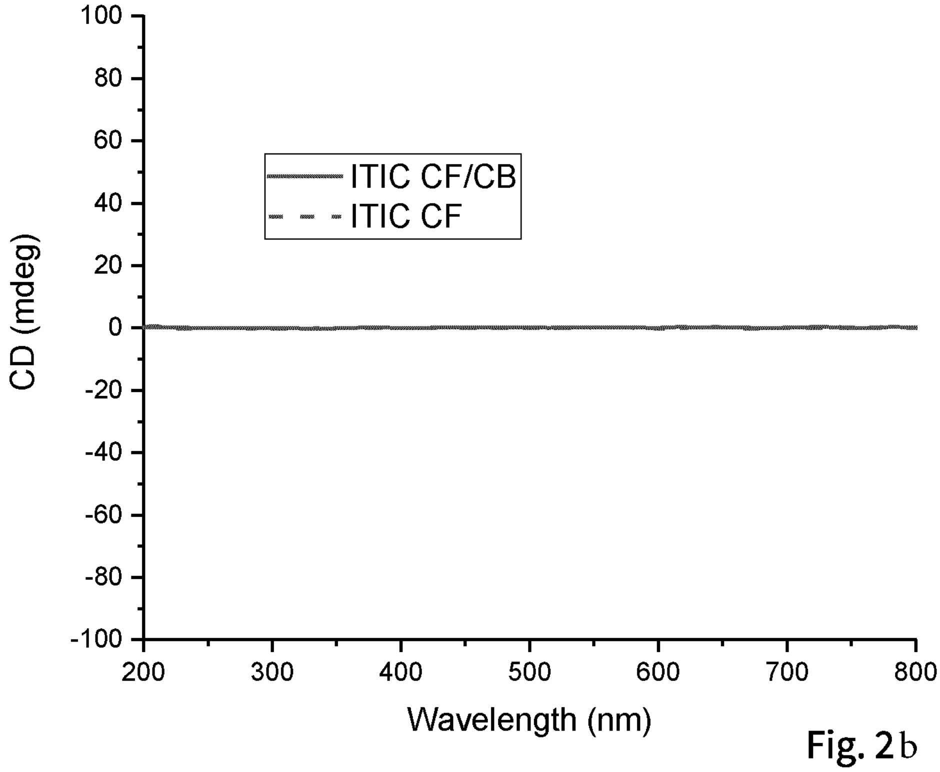
100
80
60
40
20
0
-20
-40
-60
-80
-100
CD (mdeg)
ITIC CF/CB
ITIC CF
200
300
400
500
600
700
800
Wavelength (nm)

Fig. 2b

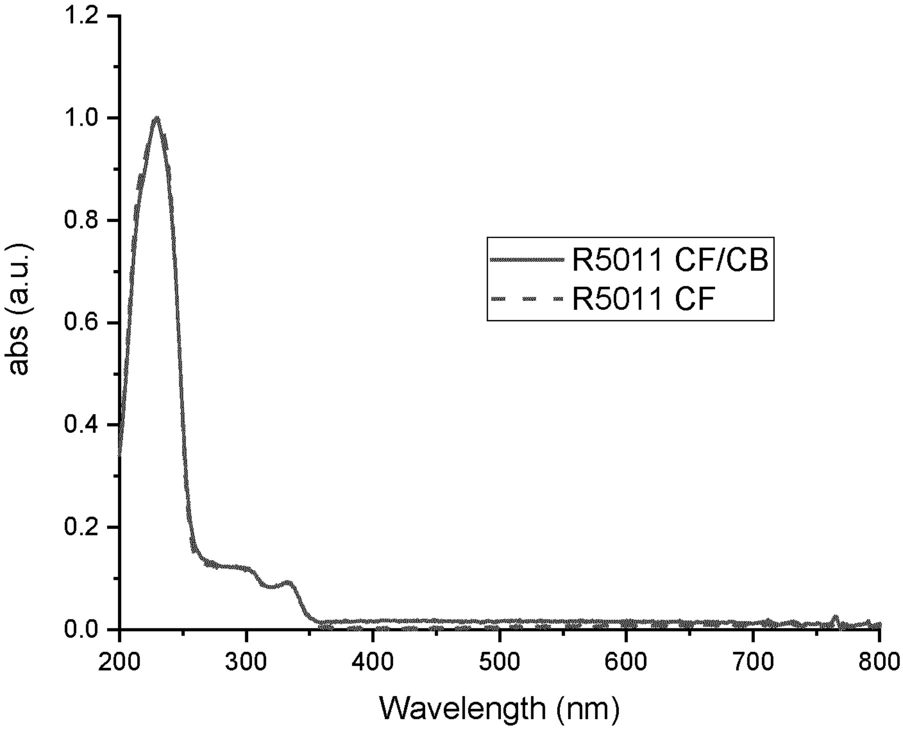
1.2
1.0
0.8
0.6
0.4
0.2
0.0
abs (a.u.)
R5011 CF/CB
R5011 CF
200
300
400
500
600
700
800
Wavelength (nm)

Fig. 3a

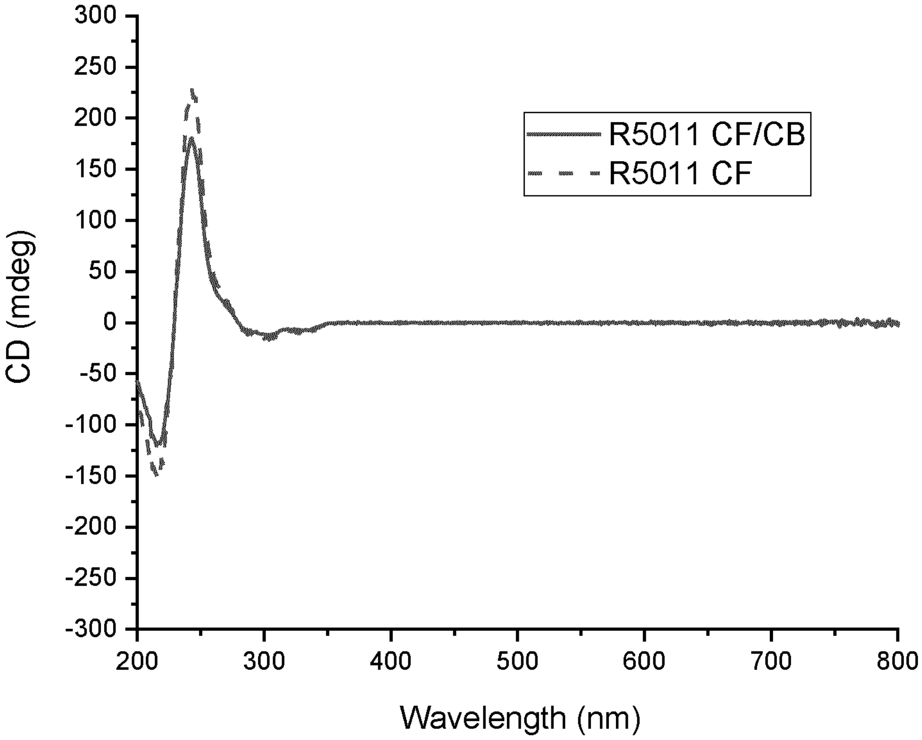
300
250
200
150
100
50
0
-50
-100
-150
-200
-250
-300
CD (mdeg)
R5011 CF/CB
R5011 CF
200
300
400
500
600
700
800
Wavelength (nm)

Fig. 3b

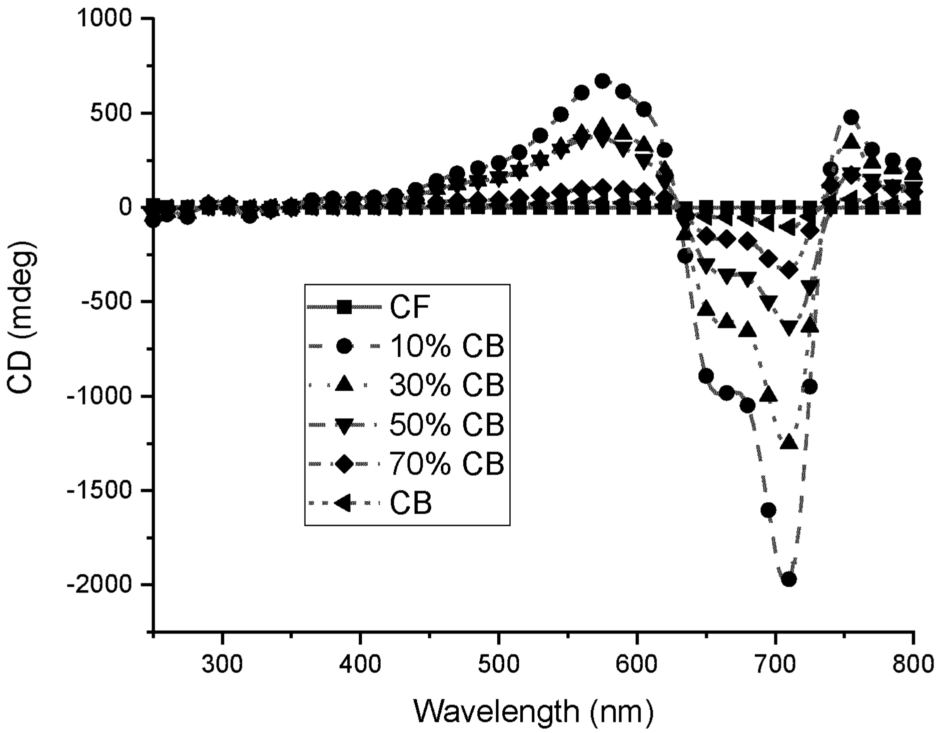
1000
500
0
-500
-1000
-1500
-2000
CD (mdeg)
300
400
500
600
700
800
Wavelength (nm)
CF
10% CB
30% CB
50% CB
70% CB
CB

Fig. 4a

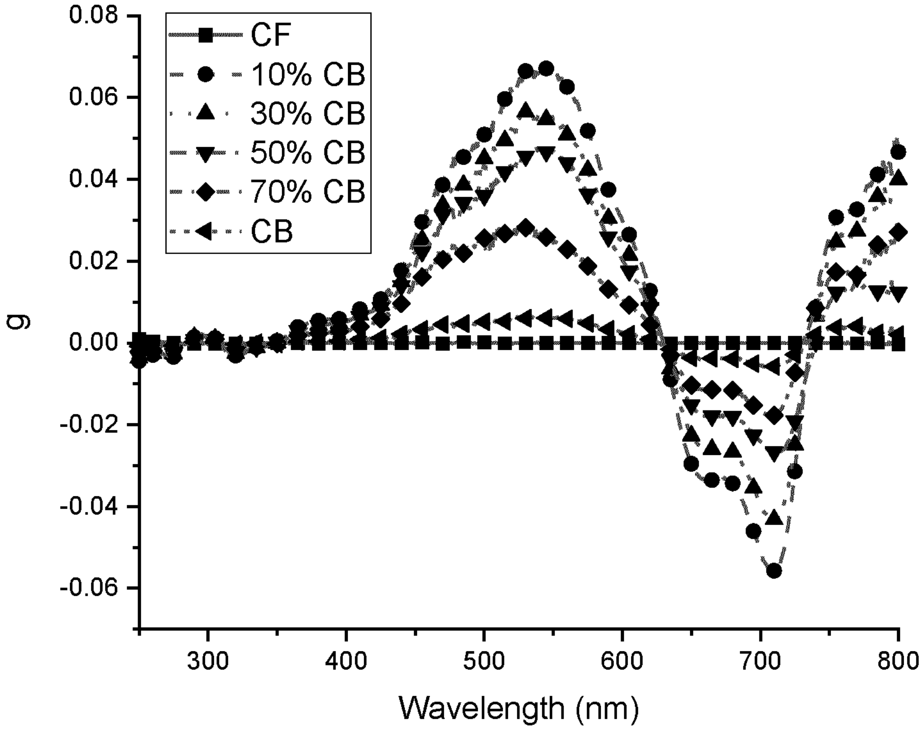
0.08
0.06
0.04
0.02
0.00
-0.02
-0.04
-0.06
g
300
400
500
600
700
800
Wavelength (nm)
CF
10% CB
30% CB
50% CB
70% CB
CB

Fig. 4b

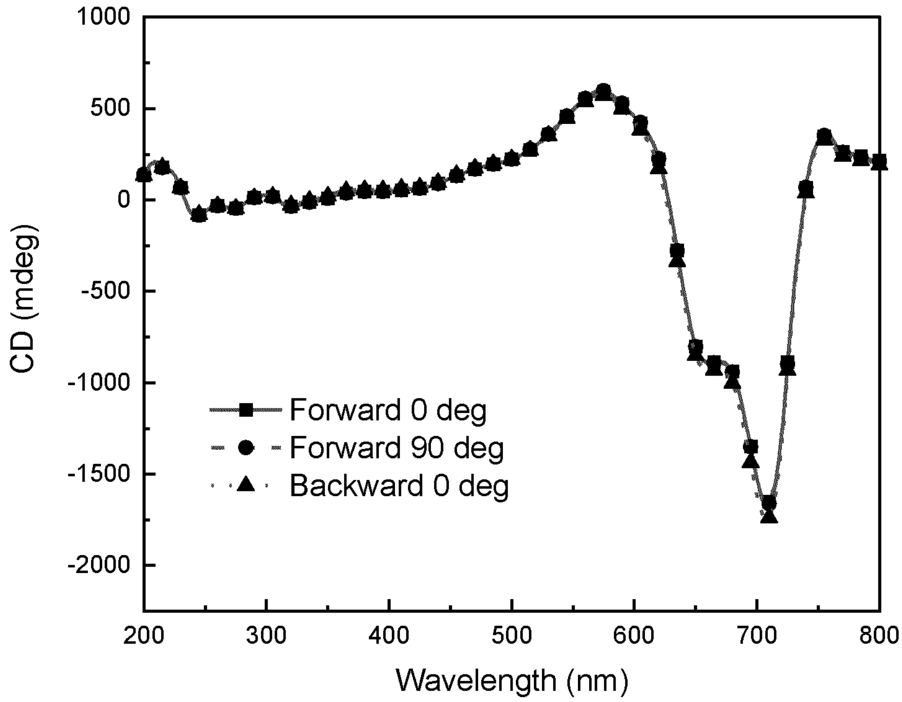
1000
500
0
-500
-1000
-1500
-2000
CD (mdeg)
200
300
400
500
600
700
800
Wavelength (nm)
Forward 0 deg
Forward 90 deg
Backward 0 deg

Fig. 5

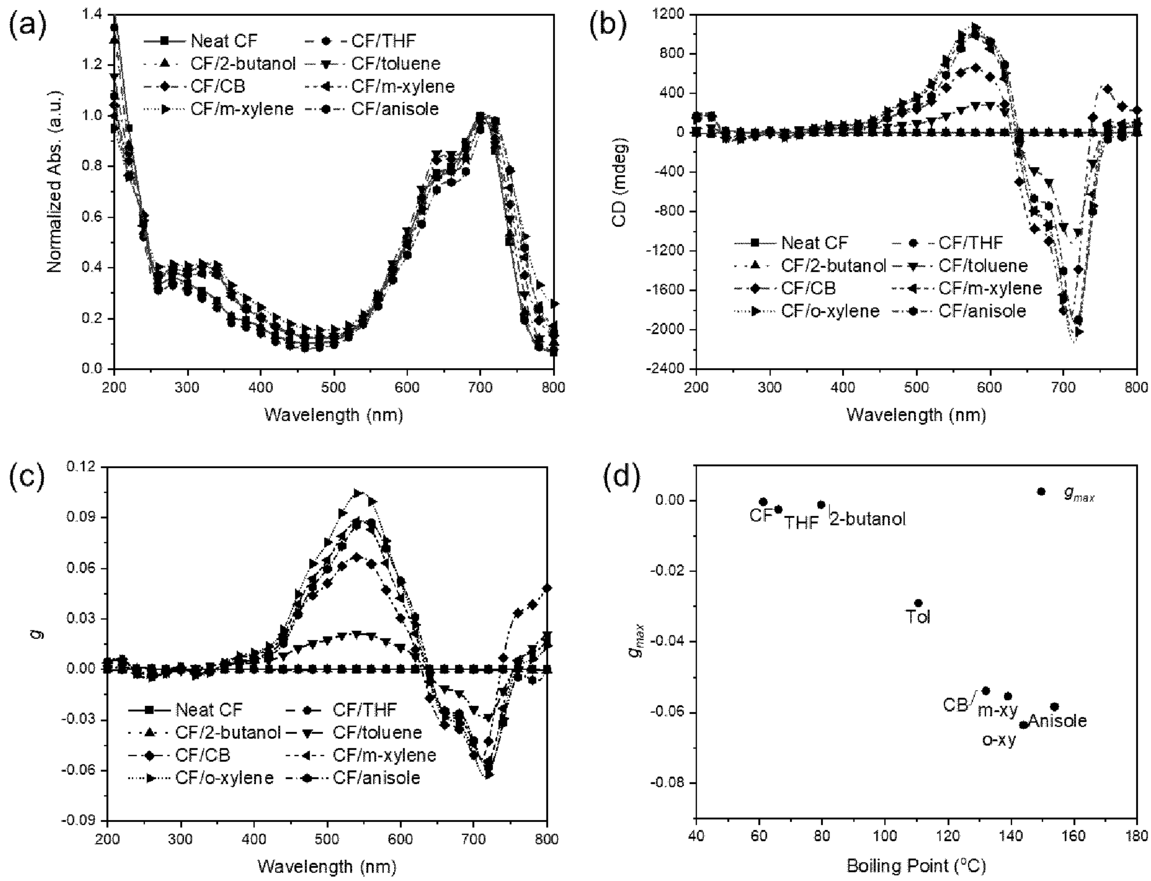
(a)
Normalized Abs. (a.u.)
Wavelength (nm)
Neat CF
CF/THF
CF/2-butanol
CF/toluene
CF/CB
CF/m-xylene
CF/m-xylene
CF/anisole
(b)
CD (mdeg)
Wavelength (nm)
Neat CF
CF/THF
CF/2-butanol
CF/toluene
CF/CB
CF/m-xylene
CF/o-xylene
CF/anisole
(c)
g
Wavelength (nm)
Neat CF
CF/THF
CF/2-butanol
CF/toluene
CF/CB
CF/m-xylene
CF/o-xylene
CF/anisole
(d)
$g_{max}$
Boiling Point (°C)
CF
THF
2-butanol
Tol
CB
m-xy
o-xy
Anisole

Fig. 6

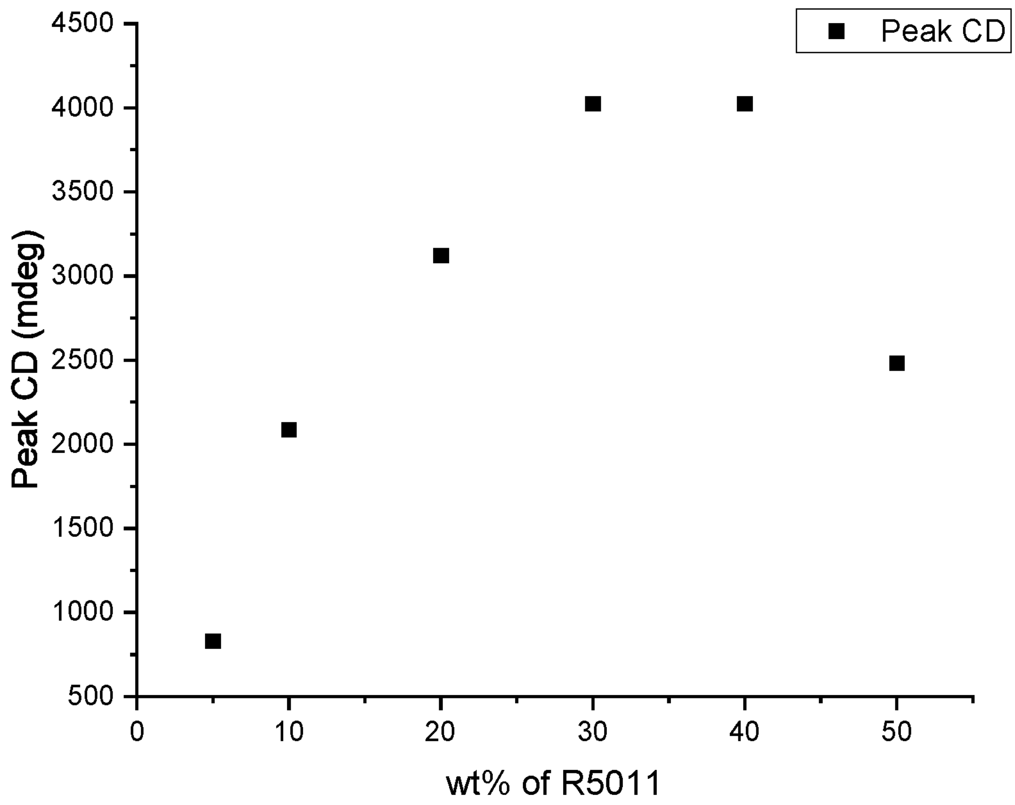
Peak CD
4500
4000
3500
3000
2500
2000
1500
1000
500
Peak CD (mdeg)
0
10
20
30
40
50
wt% of R5011

Fig. 7

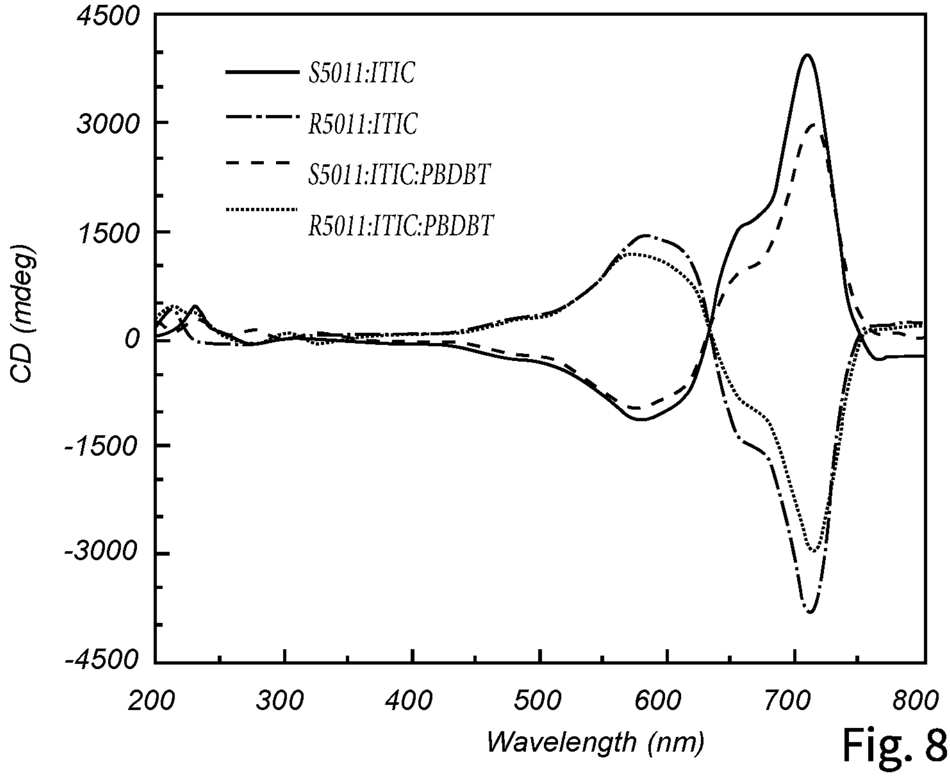
4500
3000
1500
0
-1500
-3000
-4500
CD (mdeg)
200
300
400
500
600
700
800
Wavelength (nm)
S5011:ITIC
R5011:ITIC
S5011:ITIC:PBDBT
R5011:ITIC:PBDBT

Fig. 8a

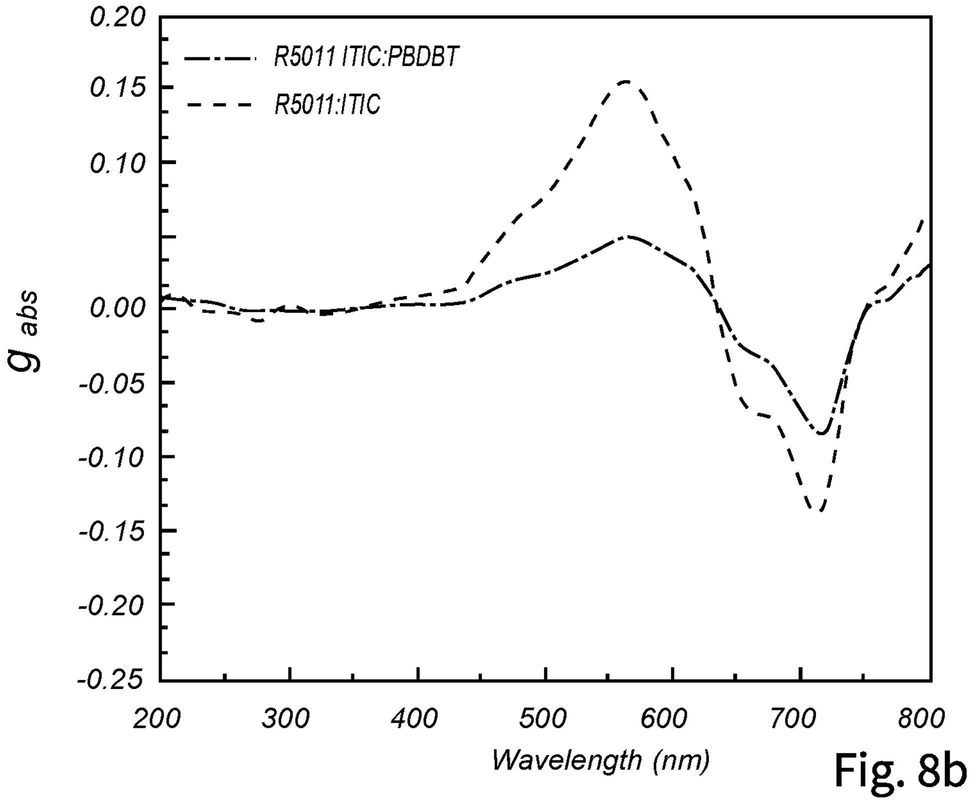
0.20
0.15
0.10
0.00
-0.05
-0.10
-0.15
-0.20
-0.25
$g_{abs}$
200
300
400
500
600
700
800
Wavelength (nm)
R5011 ITIC:PBDBT
R5011:ITIC

Fig. 8b

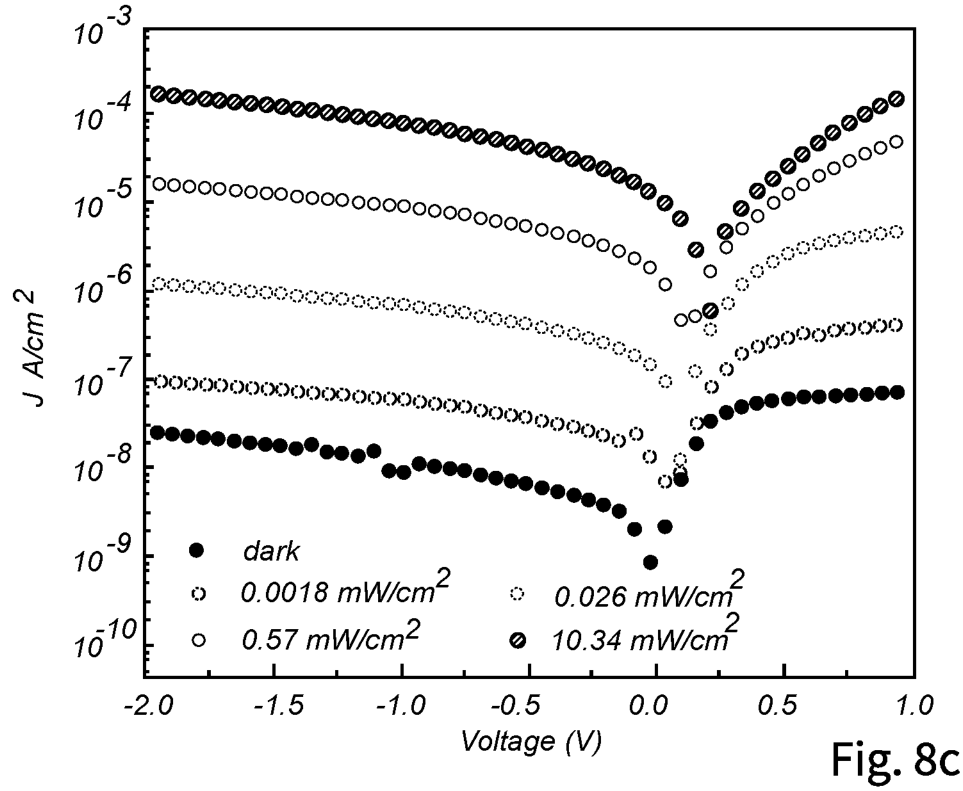
$10^{-3}$
$10^{-4}$
$10^{-5}$
$10^{-6}$
$10^{-7}$
$10^{-8}$
$10^{-9}$
$10^{-10}$
J A/cm 2
dark
0.0018 mW/cm2
0.026 mW/cm2
0.57 mW/cm2
10.34 mW/cm2
-2.0
-1.5
-1.0
-0.5
0.0
0.5
1.0
Voltage (V)

Fig. 8c

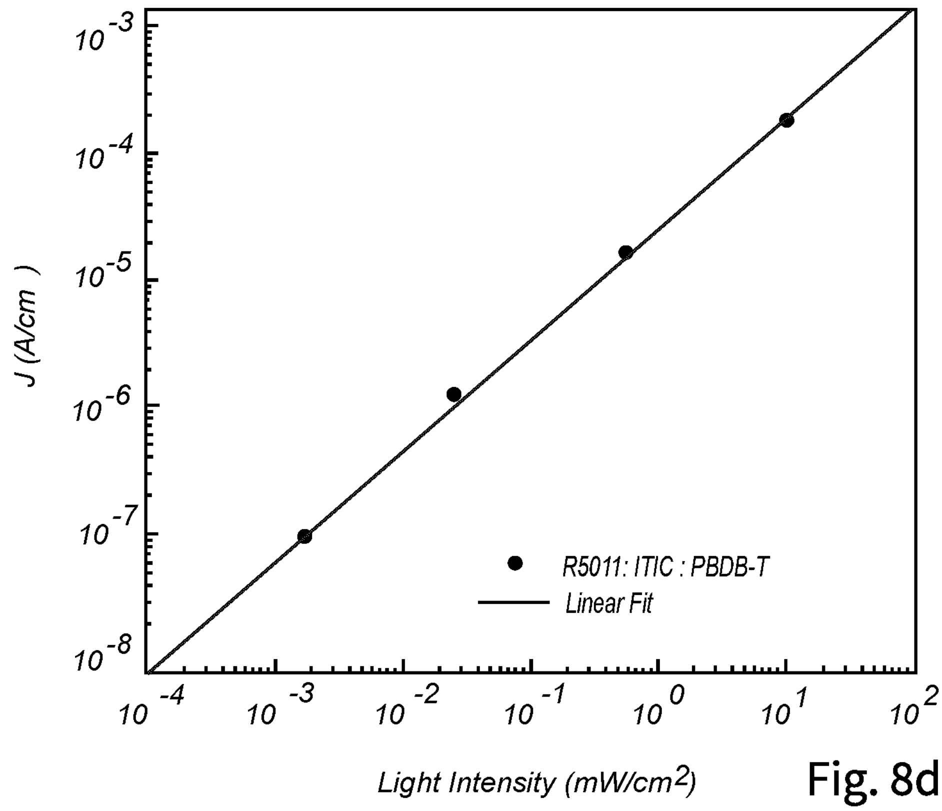
$10^{-3}$
$10^{-4}$
$10^{-5}$
$10^{-6}$
$10^{-7}$
$10^{-8}$
J (A/cm )
R5011: ITIC : PBDB-T
Linear Fit
$10^{-4}$
$10^{-3}$
$10^{-2}$
$10^{-1}$
$10^{0}$
$10^{1}$
$10^{2}$
Light Intensity (mW/cm2)

Fig. 8d

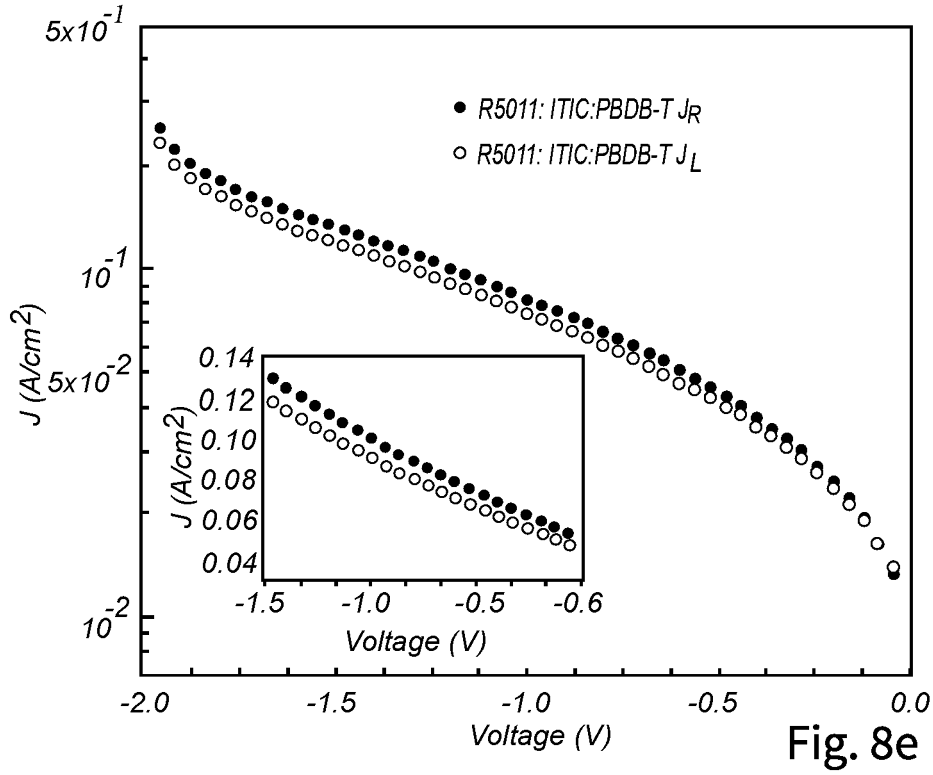
5x10^-1
10^-1
5x10^-2
10^-2
J (A/cm2)
R5011: ITIC:PBDB-T J_R
R5011: ITIC:PBDB-T J_L
0.14
0.12
0.10
0.08
0.06
0.04
-1.5
-1.0
-0.5
-0.6
Voltage (V)
-2.0
-1.5
-1.0
-0.5
0.0
Voltage (V)

Fig. 8e

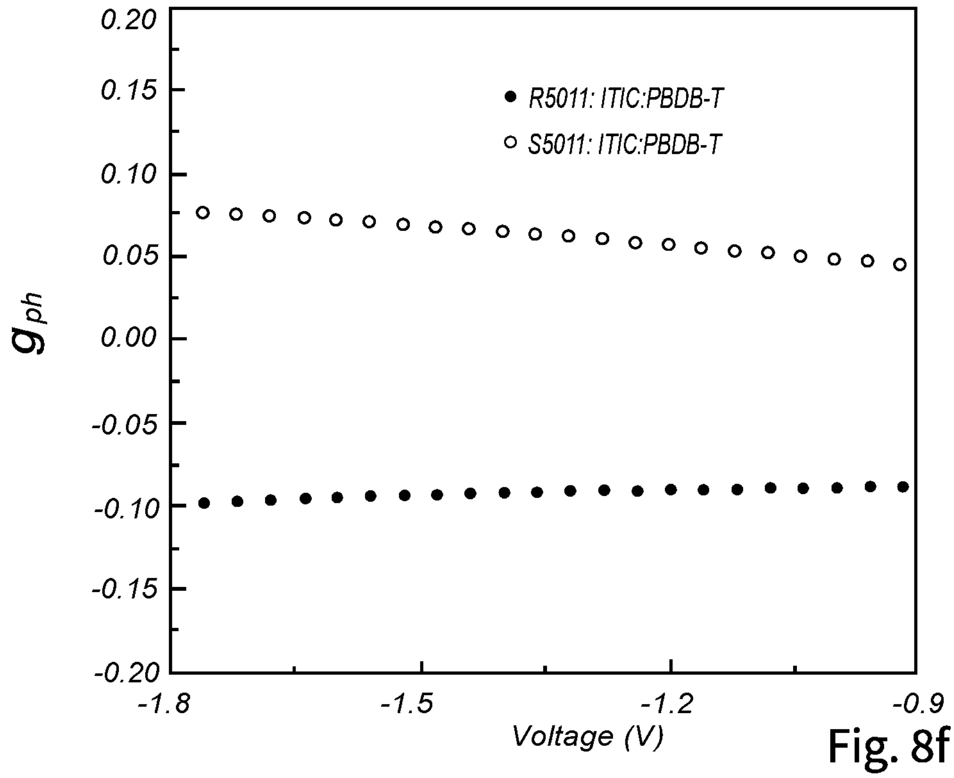
0.20
0.15
0.10
0.05
0.00
-0.05
-0.10
-0.15
-0.20
g_ph
R5011: ITIC:PBDB-T
S5011: ITIC:PBDB-T
-1.8
-1.5
-1.2
-0.9
Voltage (V)

Fig. 8f

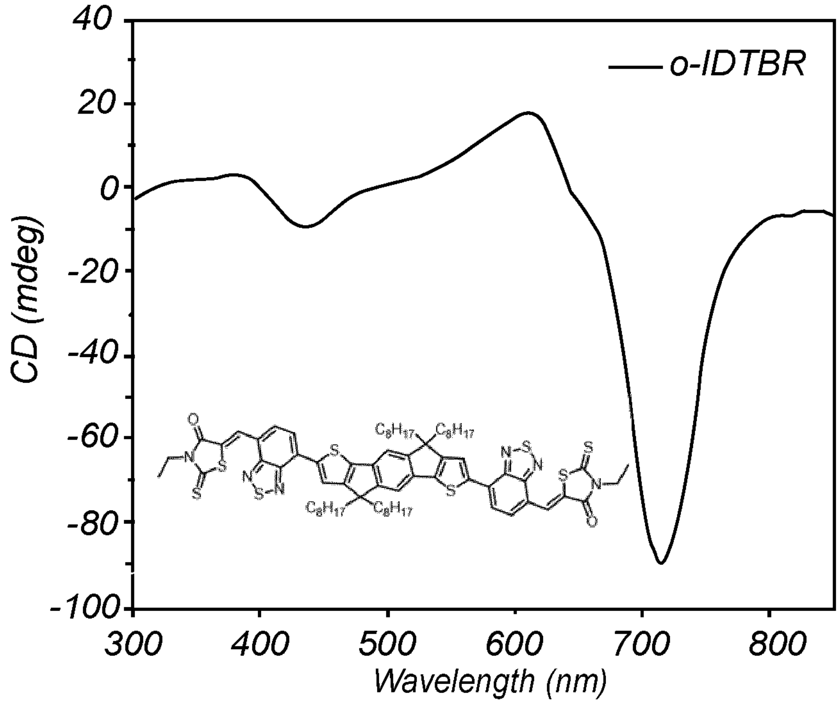
o-IDTBR
CD (mdeg)
40
20
0
-20
-40
-60
-80
-100
300
400
500
600
700
800
Wavelength (nm)

Fig. 9a

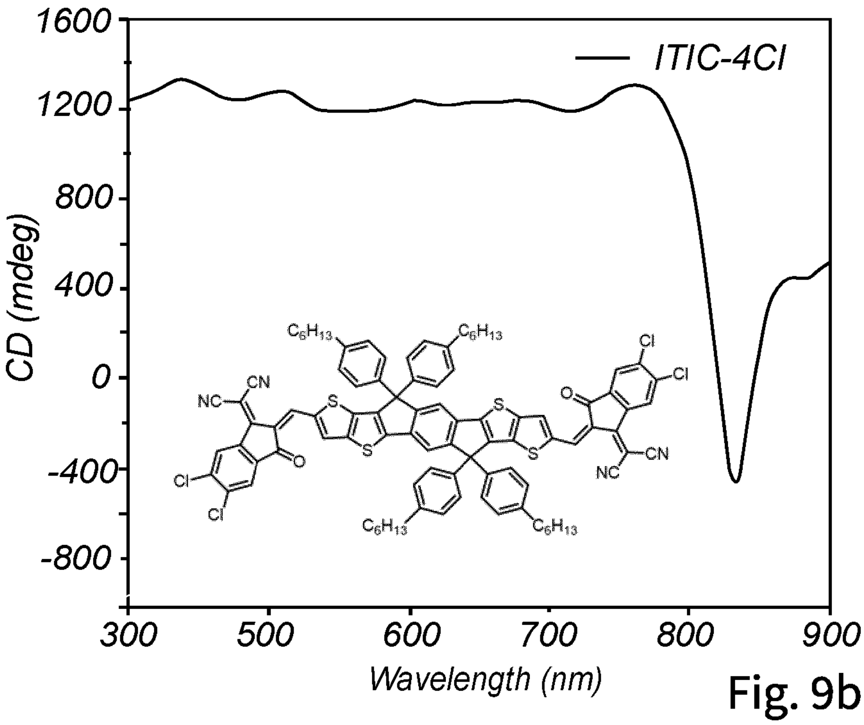
ITIC-4Cl
CD (mdeg)
1600
1200
800
400
0
-400
-800
300
500
600
700
800
900
Wavelength (nm)

Fig. 9b

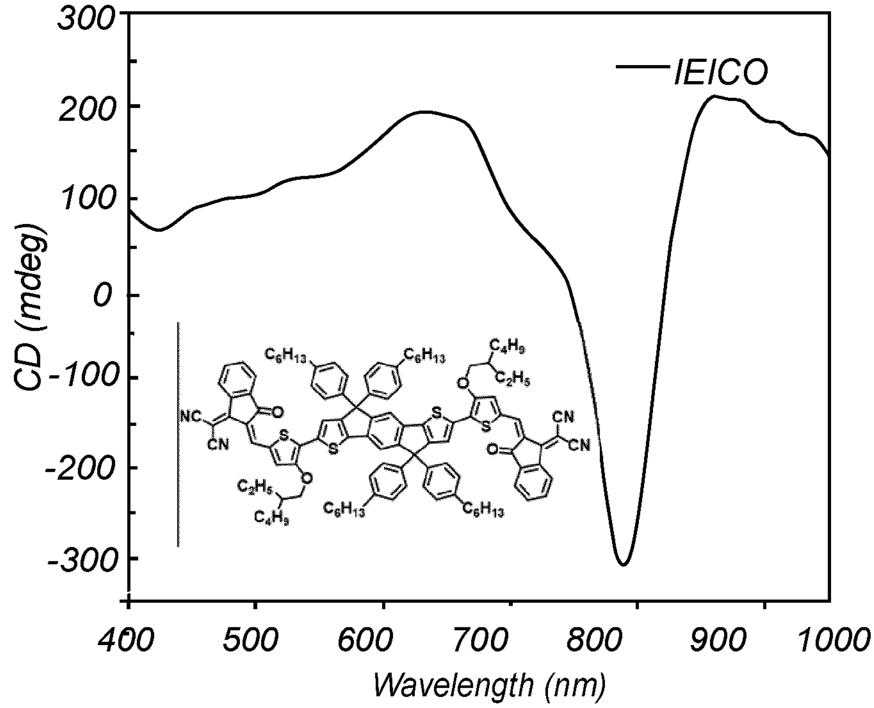
IEICO
CD (mdeg)
300
200
100
0
-100
-200
-300
400
500
600
700
800
900
1000
Wavelength (nm)

Fig. 9c

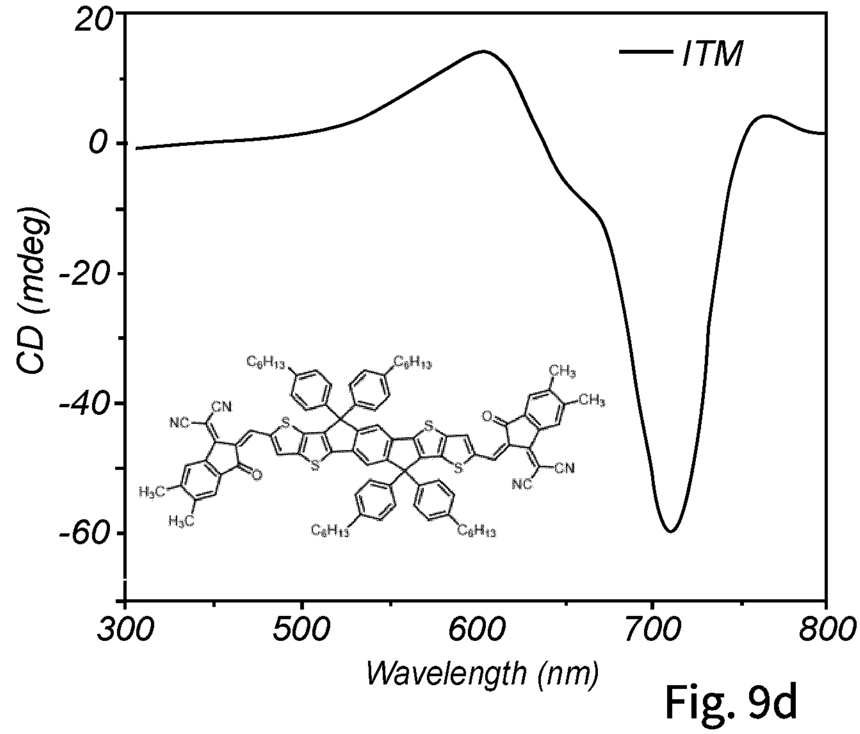
ITM
CD (mdeg)
20
0
-20
-40
-60
300
500
600
700
800
Wavelength (nm)

Fig. 9d

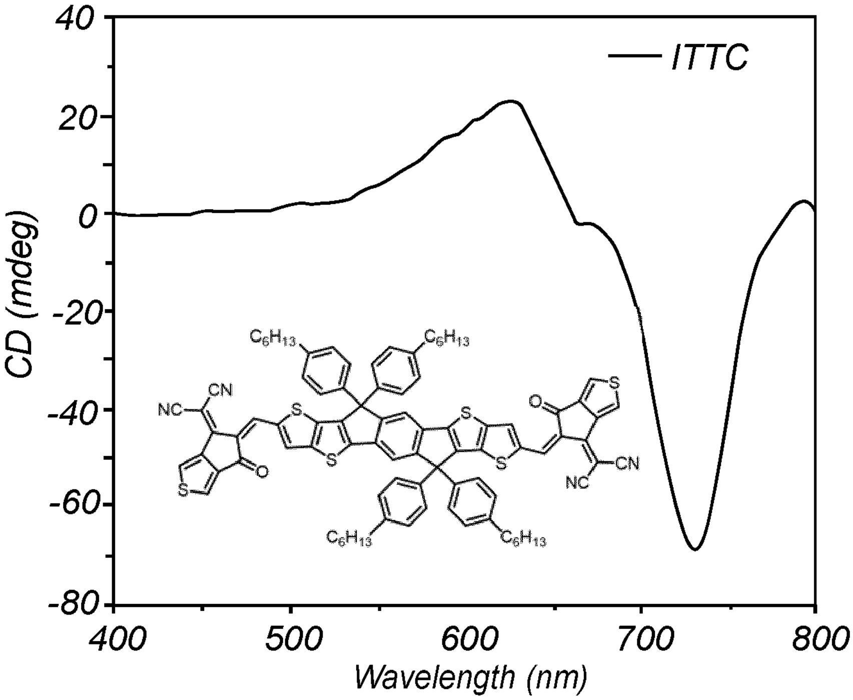
ITTC
CD (mdeg)
40
20
0
-20
-40
-60
-80
400
500
600
700
800
Wavelength (nm)

Fig. 9e

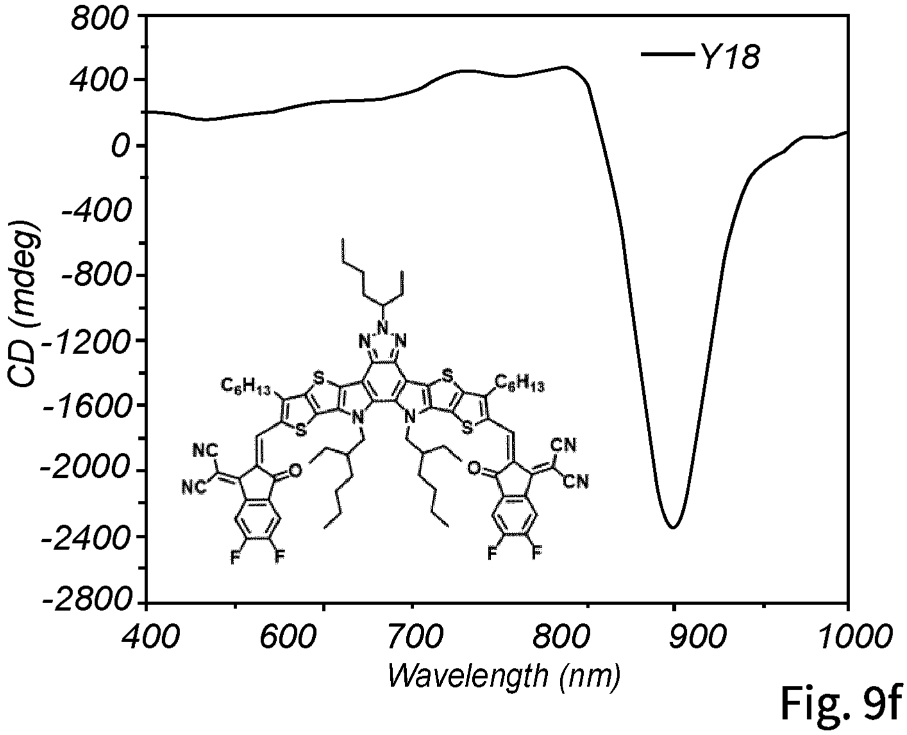
Y18
CD (mdeg)
800
400
0
-400
-800
-1200
-1600
-2000
-2400
-2800
400
600
700
800
900
1000
Wavelength (nm)

Fig. 9f

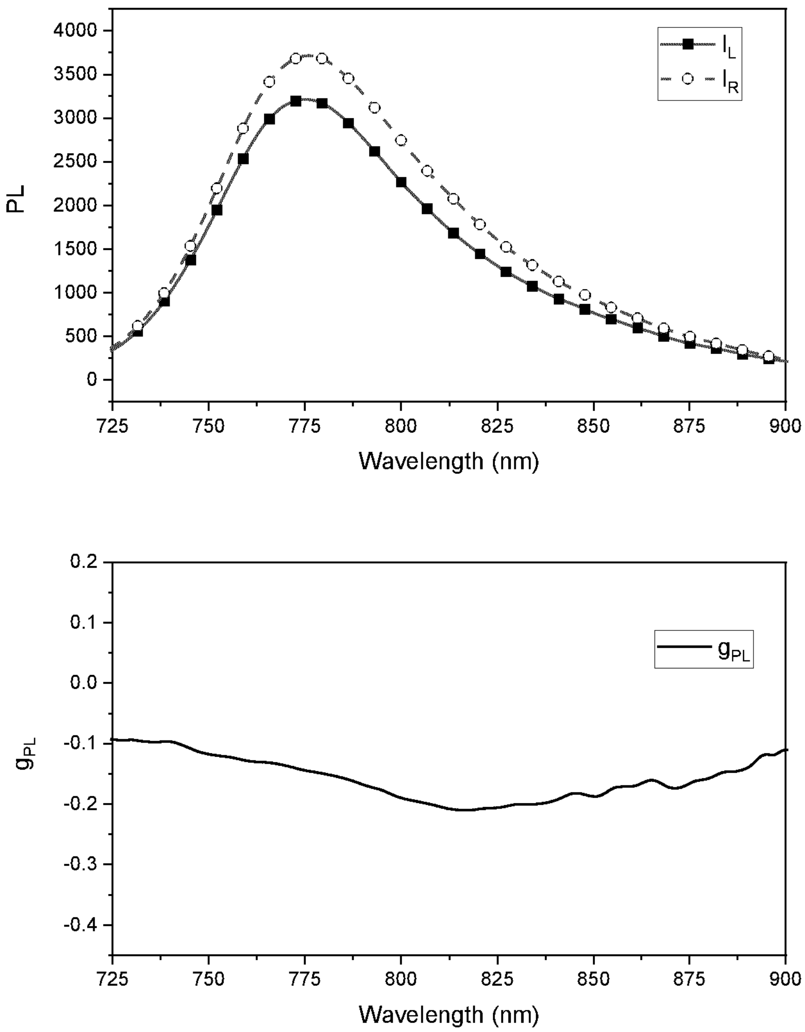
4000
3500
3000
2500
2000
1500
1000
500
0
PL
725
750
775
800
825
850
875
900
Wavelength (nm)
$I_L$
$I_R$
0.2
0.1
0.0
-0.1
-0.2
-0.3
-0.4
$g_{PL}$
725
750
775
800
825
850
875
900
Wavelength (nm)
$g_{PL}$

Fig. 10

Europäisches Patentamt
European Patent Office
Office européen des brevets

# EUROPEAN SEARCH REPORT

Application Number
EP 21 21 4775

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YU ZHONG ET AL: "Efficient Organic Solar Cells with Helical Perylene Diimide Electron Acceptors", JOURNAL OF THE AMERICAN CHEMICAL SOCIETY, vol. 136, no. 43, 14 October 2014 (2014-10-14), pages 15215-15221, XP055570993, ISSN: 0002-7863, DOI: 10.1021/ja5092613 * figure 1a; table 1; compounds PDI1+ PTB7, PDI1+PBDTT-TT * ----- | 1-4 | INV. H01L51/46 |
| Y | WO 2019/165890 A1 (UNIV HONG KONG SCI & TECH [CN]) 6 September 2019 (2019-09-06) * paragraph [0202]; figure fig.1; compound mCP+ compounds of fig.1 * ----- | 1,11,12 | |
| Y | YUZE LIN ET AL: "An Electron Acceptor Challenging Fullerenes for Efficient Polymer Solar Cells", ADVANCED MATERIALS, vol. 27, no. 7, 7 January 2015 (2015-01-07), pages 1170-1174, XP055433472, DE ISSN: 0935-9648, DOI: 10.1002/adma.201404317 * figures 1a,2B; table 1; compound ITIC * ----- | 1,5-15 | |
| | -/-- | | TECHNICAL FIELDS SEARCHED (IPC) |
| | | | H01L |

The present search report has been drawn up for all claims

1

| Place of search | Date of completion of the search | Examiner |
|---|---|---|
| The Hague | 18 May 2022 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 21 21 4775

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | YONGGANG ZHEN ET AL: "Organic Solid Solution Composed of Two Structurally Similar Porphyrins for Organic Solar Cells", JOURNAL OF THE AMERICAN CHEMICAL SOCIETY, vol. 137, no. 6, 18 February 2015 (2015-02-18), pages 2247-2252, XP055220558, ISSN: 0002-7863, DOI: 10.1021/ja513045a * page 2251, column 1, lines 45-46; figures 1a,4,5; compound BP:CABP:SIMEF2 * ----- | 1,5-10, 13-15 | |
| A | WO 2014/016611 A1 (IMP INNOVATIONS LMIITED [GB]) 30 January 2014 (2014-01-30) * the whole document * ----- | 1-15 | |

TECHNICAL FIELDS SEARCHED (IPC)

The present search report has been drawn up for all claims

| Place of search | Date of completion of the search | Examiner |
|---|---|---|
| The Hague | 18 May 2022 | Fratiloiu, Silvia |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 21 21 4775

This annex lists the patent family members relating to the patent documents cited in the above-mentioned European search report. The members are as contained in the European Patent Office EDP file on
The European Patent Office is in no way liable for these particulars which are merely given for the purpose of information.

18-05-2022

| Patent document cited in search report | Publication date | Patent family member(s) | Publication date |
| --- | --- | --- | --- |
| WO 2019165890 A1 | 06-09-2019 | US 2021119143 A1 | 22-04-2021 |
| | | WO 2019165890 A1 | 06-09-2019 |
| WO 2014016611 A1 | 30-01-2014 | EP 2877552 A1 | 03-06-2015 |
| | | US 2015184068 A1 | 02-07-2015 |
| | | WO 2014016611 A1 | 30-01-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *Adv. Funct. Mater.,* 2019, vol. 29, 1900684
- *Adv. Mater.,* 2021, vol. 33, 2004115
- *Adv. Opt. Mater.,* 2021, 2101044
- *Sci. Adv.,* 2020, vol. 6, eabd3274
- *Nat. Commun.,* 2021, vol. 12, 1
- *Adv. Mater.,* 2015, vol. 27, 1170
- *Nat. Commun.,* 2016, vol. 7, 11585
- *Adv. Mater.,* 2016, vol. 28, 8283
- *J. Mater. Chem. A,* 2020, vol. 8, 8566
- *Adv. Mater.,* 2018, vol. 30, 1800613
- *Adv. Mater.,* 2016, vol. 28, 9423
- *Sol. RRL,* 2017, vol. 1, 1700044